# EUROPEAN PATENT APPLICATION

(11) **EP 4 597 589 A1**
(43) Date of publication of application: **06.08.2025**
(21) Application number: 23872939.6
(22) Date of filing: 21.09.2023
(51) Int. Cl.: H01L 33/44, H01L 33/08, H01L 33/38, H01L 33/62, H01L 33/42, H01L 33/48, H01L 25/075

(54) **LIGHT-EMITTING DEVICE AND LIGHT-EMITTING MODULE COMPRISING SAME**

(30) Priority: 30.09.2022 US 202263411634 P; 20.04.2023 US 202363497232 P; 20.04.2023 US 202363497234 P; 22.06.2023 US 202363522468 P; 18.09.2023 US 202318369497
(71) Applicant: Seoul Viosys Co., Ltd., Ansan-si, Gyeonggi-do 15429 (KR)
(72) Inventor: CHA, Namgoo, Ansan-si, Gyeonggi-do 15429 (KR); JANG, Jong Min, Ansan-si, Gyeonggi-do 15429 (KR)
(74) Representative: Stolmár & Partner Patentanwälte PartG mbB
(86) International application number: PCT/KR2023/014345
(87) International publication number: WO 2024/071822

(57) **Abstract**

A light-emitting device according to an embodiment includes: a substrate; first to third LED stacks disposed on the substrate and each including a first conductivity type semiconductor layer, an active layer, and a second conductivity type semiconductor layer; a lower insulating layer covering the first to third LED stacks; an upper insulating layer disposed on the lower insulating layer; and electrode pad layers disposed on the upper insulating layer and electrically connected to the first to third LED stacks, wherein the lower insulating layer has openings that allow electrical connection to the first to third LED stacks, the upper insulating layer covers the lower insulating layer such that each of the openings of the lower insulating layer is at least partially exposed, and the electrode pad layers extend on the upper insulating layer and pass through the openings in the lower insulating layer.

## Description

### [Technical Field]

The present disclosure relates to a light emitting device and a light emitting module including the same.

### [Background Art]

A light emitting device is a semiconductor device using a light emitting diode, which is an inorganic light source, and is widely used in various fields such as display apparatuses, vehicle lamps, general lighting, and others. The light emitting diode has advantages of long lifespan, low power consumption, and fast response speed, and thus, the light emitting diode has been rapidly replacing a conventional light source.

Conventional light emitting devices have been generally used as backlight light sources in display apparatuses, and display apparatuses that directly realize images using the light emitting devices have been recently developed. Such displays are also referred to as micro LED displays.

In general, the display apparatus displays various colors through mixture of blue, green, and red light. In order to realize various images, the display apparatus includes a plurality of pixels, each including sub-pixels corresponding to one of blue, green, and red light. As such, a color of a certain pixel is typically determined based on the colors of the sub-pixels, so that images can be realized through the combination of such pixels.

In a case of a micro LED display, a micro LED is arranged on a plane corresponding to each sub-pixel, and a large number of micro LEDs are mounted on one substrate. However, since micro LEDs are very small, such as less than 200µm, further less than 100µm, it is quite difficult to transfer the micro LEDs to a circuit board. In addition, even after small sized-light emitting diodes are mounted on the circuit board, a technique for physically protecting the light emitting device without optical distortion or loss of luminance is also required.

Meanwhile, to reduce a difficulty of mounting micro LEDs, stacked micro LEDs in which blue, green, and red LEDs are stacked vertically have been developed. Since the stacked micro LEDs are arranged in pixel units on a plane, a mounting process can be simplified. However, an electrical connection structure becomes complicated as the sub-pixels are stacked, thereby making it difficult to manufacture the stacked micro LEDs.

### Summary

### [Disclosure]

### [Technical Problem]

Exemplary embodiments of the present disclosure provide a light emitting device having a novel structure in which luminance of red light is increased in a multilayer structured light emitting device for a micro LED display.

Exemplary embodiments of the present disclosure provide a light emitting device having a novel structure that is configured to simplify a structure of a stacked micro LED.

Exemplary embodiments of the present disclosure provide a light emitting device having a novel structure that is configured to improve a performance and reliability of a device in a multilayer structured light emitting device for a micro LED display.

### [Technical Solution]

A light emitting device according to an embodiment of the present disclosure includes a substrate; a first LED stack disposed on the substrate, and including a first conductivity type semiconductor layer, an active layer, and a second conductivity type semiconductor layer; a second LED stack disposed between the substrate and the first LED stack, and including a first conductivity type semiconductor layer, an active layer, and a second conductivity type semiconductor layer; a third LED stack disposed between the substrate and the second LED stack, and including a first conductivity type semiconductor layer, an active layer, and a second conductivity type semiconductor layer; and first through third contact electrodes in ohmic contact with the second conductivity type semiconductor layers of the first through third LED stacks, respectively, in which the first conductivity type semiconductor layer of the first LED stack is disposed to face the first conductivity type semiconductor layer of the second LED stack, and the second conductivity type semiconductor layer of the second LED stack is disposed to face the second conductivity type semiconductor layer of the third LED stack.

The first conductivity type semiconductor layer of the first LED stack may include a micro-optic interface.

A depth of the micro-optic interface may be in a range of 0.1µm to 0.9µm.

A sidewall of a concave portion of the micro-optic interface may have an inclination angle within a range of 35 degrees to 65 degrees.

The light emitting device may further include a first adhesive layer coupling the first LED stack and the second LED stack; and a second adhesive layer coupling the second LED stack and the third LED stack, in which the first adhesive layer may include regions having different thicknesses from one another.

The second adhesive layer may have a thickness between a maximum thickness and a minimum thickness of the first adhesive layer.

The first adhesive layer may include a material different from that of the second adhesive layer.

The light emitting device may include a first insulation layer covering side surfaces of the first through third LED stacks; and a second insulation layer disposed on the first insulation layer, in which the second insulation layer may be thicker than the first insulation layer.

The first insulation layer may have through-holes exposing the first through third contact electrodes.

The second insulation layer may include a distributed Bragg reflector.

The distributed Bragg reflector may have a reflectance of 80% or more for light in a wavelength range of 600nm to 650nm.

The distributed Bragg reflector may have a thickness in a range of 1.5µm to 3µm.

The distributed Bragg reflector may include 16 to 25 pairs of material layers having different refractive indices from one another.

The first insulation layer may be formed of SiO₂, and the distributed Bragg reflector of the second insulation layer may be formed by alternately stacking SiO₂ and TiO₂.

A light emitting module according to an embodiment of the present disclosure includes a circuit board; and a light emitting device disposed on the circuit board, in which the light emitting device includes: a substrate; a first LED stack disposed on the substrate, and including a first conductivity type semiconductor layer, an active layer, and a second conductivity type semiconductor layer; a second LED stack disposed between the substrate and the first LED stack, and including a first conductivity type semiconductor layer, an active layer, and a second conductivity type semiconductor layer; a third LED stack disposed between the substrate and the second LED stack, and including a first conductivity type semiconductor layer, an active layer, and a second conductivity type semiconductor layer; and first through third contact electrodes in ohmic contact with the second conductivity type semiconductor layers of the first through third LED stacks, respectively, in which the first conductivity type semiconductor layer of the first LED stack is disposed to face the first conductivity type semiconductor layer of the second LED stack, and the second conductivity type semiconductor layer of the second LED stack is disposed to face the second conductivity type semiconductor layer of the third LED stack.

The first conductivity type semiconductor layer of the first LED stack may include a micro-optic interface.

The light emitting device may further include a first adhesive layer coupling the first LED stack and the second LED stack; and a second adhesive layer coupling the second LED stack and the third LED stack, in which the first adhesive layer may include regions having different thicknesses from one another.

The second adhesive layer may have a thickness between a maximum thickness and a minimum thickness of the first adhesive layer.

The light emitting device may further include a first insulation layer covering side surfaces of the first through third LED stacks; and a second insulation layer disposed on the first insulation layer, in which the second insulation layer may be thicker than the first insulation layer.

The first insulation layer may be formed of SiO₂, and the second insulation layer may include a distributed Bragg reflector having a reflectance of 80% or more for light in a wavelength range of 600nm to 650nm.

A light emitting device according to an embodiment of the present disclosure includes: a substrate; first through third LED stacks disposed on the substrate, and including a first conductivity type semiconductor layer, an active layer, and a second conductivity type semiconductor layer, respectively; a lower insulation layer covering the first through third LED stacks; an upper insulation layer disposed on the lower insulation layer; and electrode pad layers disposed on the upper insulation layer, and electrically connected to the first through third LED stacks, in which the lower insulation layer has openings allowing electrical connection to the first through third LED stacks, the upper insulation layer covers the lower insulation layer such that each of the openings in the lower insulation layer is at least partially exposed, and the electrode pad layers extend on the upper insulation layer to pass through the openings in the lower insulation layer.

One of the electrode pad layers may be commonly electrically connected to the first conductivity type semiconductor layers of the first through third LED stacks through a plurality of openings of the lower insulation layer.

The light emitting device may further include an ohmic contact layer disposed on the first conductivity type semiconductor layer of the first LED stack, and one of the electrode pad layers may be connected to the ohmic contact layer.

One of the electrode pad layers may directly contact the first conductivity type semiconductor layers of the second LED stack and the third LED stack.

Three of the electrode pad layers may be electrically connected to the second conductivity type semiconductor layers of the first through third LED stacks, respectively, through different openings of the lower insulation layer.

The light emitting device may further include transparent electrode layers respectively disposed on the second conductivity type semiconductor layers of the first through third LED stacks, and three of the electrode pad layers may be connected to the transparent electrode layers, respectively.

The upper insulation layer may have openings corresponding to the openings in the lower insulation layer.

The upper insulation layer may include polyimide.

In an embodiment, a height of an upper most surface of the upper insulation layer may be lower than that of an upper most surface of the lower insulation layer.

The lower insulation layer may include a distributed Bragg reflector.

The lower insulation layer may contact the first conductivity type semiconductor layers of the first through third LED stacks.

At least one of the electrode pad layers may include a curved upper surface.

Each of the electrode pad layers may extend toward a center and an outside of the light emitting device from the opening of the lower insulation layer, and at least one electrode pad may extend more lengthily to the outside of the light emitting device than to the center of the light emitting device from the opening of the lower insulation layer.

The light emitting device may further include: a first adhesive layer disposed between the first LED stack and the second LED stack; and a second adhesive layer disposed between the second LED stack and the third LED stack.

A light emitting module according to an embodiment of the present disclosure includes: a circuit board having pads; a light emitting device disposed on the circuit board; and bonding layers for bonding the light emitting device to the circuit board, in which the light emitting device includes: a substrate; a first LED stack disposed on the substrate, and including a first conductivity type semiconductor layer, an active layer, and a second conductivity type semiconductor layer; a second LED stack disposed between the substrate and the first LED stack, and including a first conductivity type semiconductor layer, an active layer, and a second conductivity type semiconductor layer; a third LED stack disposed between the substrate and the second LED stack, and including a first conductivity type semiconductor layer, an active layer, and a second conductivity type semiconductor layer; a lower insulation layer covering the first through third LED stacks; an upper insulation layer disposed on the lower insulation layer; and electrode pad layers disposed on the upper insulation layer, and electrically connected to the first through third LED stacks, in which the lower insulation layer has openings allowing electrical connection to the first through third LED stacks, the upper insulation layer covers the lower insulation layer such that each of the openings in the lower insulation layer is at least partially exposed, and the electrode pad layers extend on the upper insulation layer to pass through the openings in the lower insulation layer.

The bonding layers may bond the electrode pad layers to the pads.

One of the electrode pad layers may be commonly electrically connected to the first conductivity type semiconductor layers of the first through third LED stacks through a plurality of openings of the lower insulation layer.

One of the electrode pad layers may directly contact the first conductivity type semiconductor layers of the second LED stack and the third LED stack.

Three of the electrode pad layers may be electrically connected to the second conductivity type semiconductor layers of the first through third LED stacks, respectively, through different openings of the lower insulation layer.

The lower insulation layer may include a distributed Bragg reflector, and the lower insulation layer may contact the first conductivity type semiconductor layers of the first through third LED stacks.

A light emitting device according to an embodiment of the present disclosure includes a first subunit including a first conductivity type semiconductor layer, an active layer, and a second conductivity type semiconductor layer; a second subunit disposed over the first subunit, and including a first conductivity type semiconductor layer, an active layer, and a second conductivity type semiconductor layer; a third subunit disposed over the second subunit, and including a first conductivity type semiconductor layer, an active layer, and a second conductivity type semiconductor layer; and first through third pad electrodes electrically connected to the second conductivity type semiconductor layers of the first through third subunits, respectively, in which the number of subunit overlapping with each of the first through third pad electrodes is different from one another.

The first pad electrode may be electrically connected to the first subunit , the second pad electrode may be electrically connected to the second subunit, and the third pad electrode may be electrically connected to the third subunit.

The light emitting device may further include a fourth pad electrode, and the number of subunits overlapping with at least one of the first through third pad electrodes may be equal to the number of subunits overlapping with the fourth pad electrode.

Each of the first through third pad electrodes may have different lengths.

A display apparatus includes: a circuit board; a substrate electrode disposed on the circuit board; a light emitting device electrically connected to the substrate electrode; and a molding layer covering the light emitting device, in which the light emitting device includes: a first subunit including a first conductivity type semiconductor layer, an active layer, and a second conductivity type semiconductor layer; a second subunit disposed over the first subunit, and including a first conductivity type semiconductor layer, an active layer, and a second conductivity type semiconductor layer; a third subunit disposed over the second subunit, and including a first conductivity type semiconductor layer, an active layer, and a second conductivity type semiconductor layer; and first through third pad electrodes electrically connected to the second conductivity type semiconductor layers of the first through third subunits, respectively, in which the number of subunit overlapping with each of the first through third pad electrodes is different from one another.

### [Brief Description of Drawings]

FIG. 1A is a schematic plan view illustrating a light emitting device according to an embodiment of the present disclosure.
FIG. 1B is a schematic cross-sectional view taken along line A-A' of FIG. 1A.
FIG. 1C is a schematic cross-sectional view taken along line B-B' in FIG. 1A.
FIGs. 2A, 2B, and 2C are schematic cross-sectional views illustrating steps of providing a first LED stack according to an embodiment of the present disclosure.
FIG. 3 is a schematic cross-sectional view illustrating a step of providing a second LED stack according to an embodiment of the present disclosure.
FIG. 4 is a schematic cross-sectional view illustrating a step of providing a third LED stack according to an embodiment of the present disclosure.
FIG. 5A is a schematic cross-sectional view illustrating a process of bonding a second LED stack to a third LED stack according to an embodiment of the present disclosure.
FIG. 5B is a schematic cross-sectional view illustrating a process of bonding a first LED stack to a second LED stack according to an embodiment of the present disclosure.
FIGs. 6A, 7A, 8A, 9A, and 10A are schematic plan views illustrating a method of manufacturing a light emitting device according to an embodiment of the present disclosure.
FIGs. 6B, 7B, 8B, 9B, and 10B are schematic cross-sectional views taken along line A-A' in FIGs. 6A, 7A, 8A, 9A, and 10A.
FIG. 11 is a schematic cross-sectional view illustrating a light emitting module according to an embodiment of the present disclosure.
FIG. 12A is a schematic plan view illustrating a light emitting device according to an embodiment of the present disclosure.
FIG. 12B is a schematic cross-sectional view taken along line A-A' of FIG. 12A.
FIG. 12C is a schematic cross-sectional view taken along line B-B' in FIG. 12A.
FIGs. 13A, 13B, and 13C are schematic cross-sectional views illustrating a step of providing a first LED stack according to an embodiment of the present disclosure.
FIG. 14 is a schematic cross-sectional view illustrating a step of providing a second LED stack according to an embodiment of the present disclosure.
FIG. 15 is a schematic cross-sectional view illustrating a step of providing a third LED stack according to an embodiment of the present disclosure.
FIG. 16A is a schematic cross-sectional view illustrating a process of bonding the second LED stack to the third LED stack according to an embodiment of the present disclosure.
FIG. 16B is a schematic cross-sectional view illustrating a process of bonding the first LED stack to the second LED stack according to an embodiment of the present disclosure.
FIGs.17A, 18A, 19A, 20A, and 21A are schematic plan views illustrating a method of manufacturing a light emitting device according to an embodiment of the present disclosure.
FIGs. 17B, 18B, 19B, 20B, and 21B are schematic cross-sectional views taken along line A-A' of FIGs. 17A, 18A, 19A, 20A, and 21A.
FIG. 22 is a schematic cross-sectional view illustrating a light emitting device according to another embodiment of the present disclosure.
FIG. 23 is a schematic cross-sectional view illustrating a light emitting module according to an embodiment of the present disclosure.
FIG. 24 is a schematic cross-sectional view illustrating a light emitting device according to an embodiment of the present disclosure.
FIG. 25 is a schematic plan view illustrating a light emitting device according to an embodiment of the present disclosure.
FIG. 26 is a schematic cross-sectional view illustrating a light emitting device according to an embodiment of the present disclosure.
FIG. 27 is a schematic plan view illustrating a light emitting device according to an embodiment of the present disclosure.
FIG. 28 is a schematic cross-sectional view illustrating a light emitting device according to an embodiment of the present disclosure.
FIG. 29 is a schematic cross-sectional view illustrating a light emitting device according to an embodiment of the present disclosure.
FIG. 30 is a schematic plan view illustrating a display apparatus according to an exemplary embodiment.
FIG. 31 is a schematic perspective view illustrating various display apparatuses according to an exemplary embodiment.
FIG. 32 is a schematic perspective view illustrating another display apparatus according to an exemplary embodiment.
FIG. 33 is a schematic perspective view illustrating another display apparatus according to an exemplary embodiment.

### [Best Mode]

Hereinafter, embodiments will be described in detail with reference to the accompanying drawings. The following embodiments are provided by way of example so as to fully convey the spirit of the present disclosure to those skilled in the art to which the present disclosure pertains. Accordingly, the present disclosure is not limited to the embodiments disclosed herein and can also be implemented in different forms. In the drawings, widths, lengths, thicknesses, and the like of elements can be exaggerated for clarity and descriptive purposes. When an element or layer is referred to as being "disposed above" or "disposed on" another element or layer, it can be directly "disposed above" or "disposed on" the other element or layer or intervening elements or layers can be present. Throughout the specification, like reference numerals denote like elements having the same or similar functions.

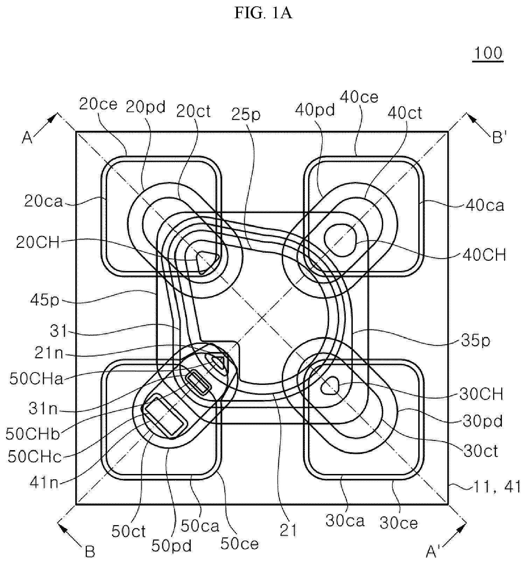

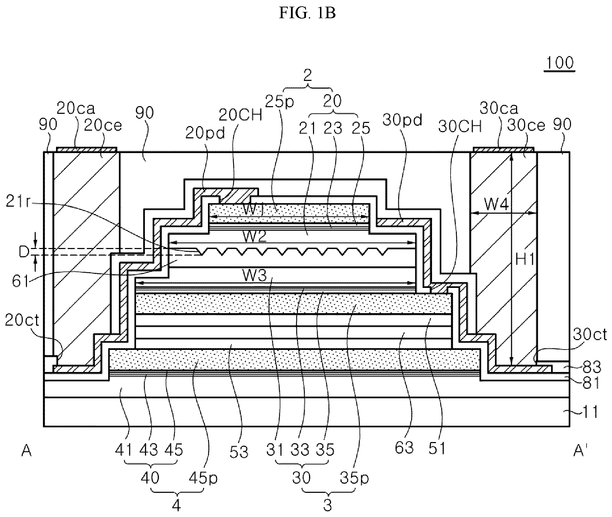

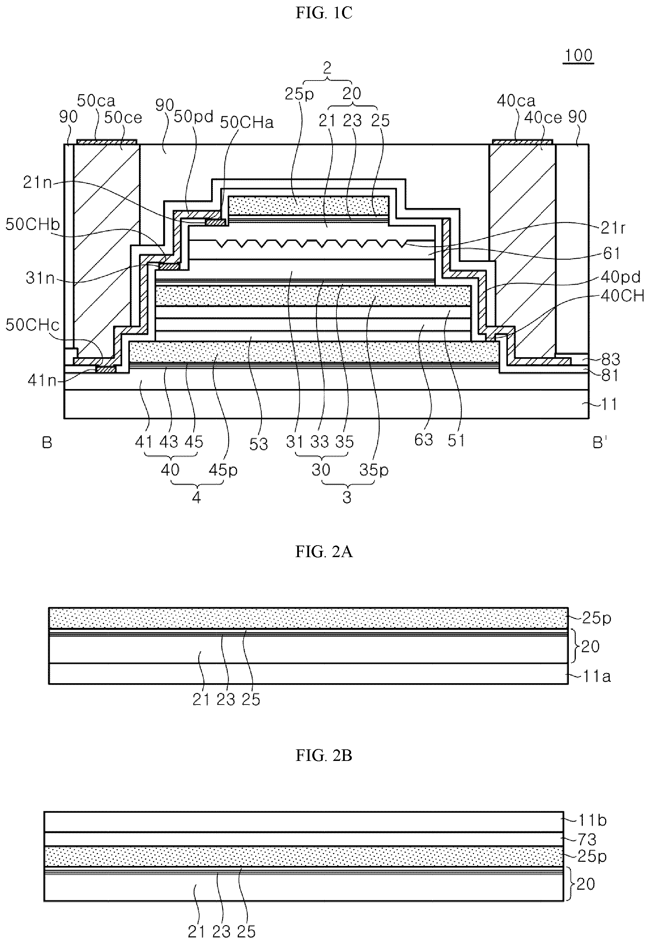

FIGs. 1A, 1B, and 1C are a schematic plan view and cross-sectional views illustrating a light emitting device 100 according to an embodiment of the present disclosure.

Referring to FIGs. 1A through 1C, the light emitting device 100 includes a substrate 11 and first, second, and third subunits 2, 3, and 4, and may include a first connection electrode 20ce, a second connection electrode 30ce, a third connection electrode 40ce, and a fourth connection electrode 50ce formed on the first, second, and third subunits 2, 3, and 4, and a protection layer 90 surrounding the connection electrodes 20ce, 30ce, 40ce, and 50ce. The light emitting device 100 shown in FIG. 1A may be formed by singularizing a plurality of light emitting device arrays formed on the substrate 11. The light emitting device 100 including the first, second, and third subunits 2, 3, and 4 may be mounted on a circuit board and formed as a light emitting module, which will be described in detail later.

The substrate 11 may include a light transmitting insulating material to transmit light. However, the inventive concepts are not limited thereto, and the substrate 11 may be formed to be translucent or partially transparent to transmit only light of a specific wavelength or only a portion of light of a specific wavelength. The substrate 11 may be a growth substrate capable of epitaxially growing a third LED stack 40, for example, a sapphire substrate. However, the substrate 11 is not limited to the sapphire substrate, and may include various other transparent insulating materials. The substrate 11 may include glass, quartz, silicon, an organic polymer, or an organic-inorganic composite material, and may be, for example, silicon carbide (SiC), gallium nitride (GaN), indium gallium nitride (InGaN), aluminum gallium nitride (AlGaN), aluminum nitride (AlN), gallium oxide (Ga2O3), or a silicon substrate.

An area of the substrate 11 may define an area of the light emitting device 100. In an embodiment, the area of the substrate 11 may be formed to be same as that of the third subunit 4. The area of the substrate 11 may be about 60,000µm² or less, and further, 30,000µm² or less, furthermore 10,000µm² or less. The substrate 11 may have a thickness of 30µm to 180µm, specifically, 30µm to 100µm. In an embodiment, the substrate 11 may have an area of 225µm × 225µm and a thickness of 50µm. As a ratio of thickness to area of the substrate 11 decreases, for a total light amount extracted to the outside, it is possible to reduce a ratio of a light amount extracted in a direction parallel to a rear surface of the substrate 11, that is, a side surface, and it is possible to increase a ratio of a light amount transmitted in a direction perpendicular to the rear surface of the substrate 11 and extracted. In particular, by reducing the thickness of the substrate 11, light emitted from the third subunit 4 adjacent to the substrate 11 may be better emitted in the direction perpendicular to the rear surface of the substrate 11. Accordingly, a color difference according to a viewing angle may be alleviated by reducing a deviation of light extracted from the light emitting device 100.

The light emitting device 100 may include the first subunit 2, the second subunit 3, and the third subunit 4 on the substrate 11 as shown in FIG. 1B. According to an embodiment, the first, second, and third subunits 2, 3 and 4 may emit light having different peak wavelengths from one another. More specifically, light emitted from the first subunit 2 may pass through the second and third subunits 3 and 4. In an embodiment, light loss may be reduced by emitting light of a wavelength longer than that of a subunit far from the substrate 11, compared to a subunit close to the substrate 11. For example, the first subunit 2 may emit light of a wavelength longer than those of the second and third subunits 3 and 4, and the second subunit 3 may emit light of a wavelength longer than those of the second and third subunits 3 and 4. For example, the first subunit 2 may emit red light, the second subunit 3 may emit green light, and the third subunit 4 may emit blue light.

In another embodiment, to adjust a color mixing ratio of the first, second, and third subunits 2, 3 and 4, the second subunit 3 may emit light of a wavelength shorter than that of the third subunit 4. Accordingly, a luminous intensity of the second subunit 3 may be reduced, a luminous intensity of the third subunit 4 may be increased, and a luminous intensity ratio of light emitted from the first, second, and third subunits 2, 3, and 4 may be controlled. For example, the light emitting device may be configured such that the first subunit 2 emits red light, the second subunit 3 emits blue light, and the third subunit 4 emits green light. Accordingly, a luminous intensity of blue light may be relatively reduced and a luminous intensity of green light may be relatively increased, and thus, a luminous intensity ratio of red, green, and blue may be adjusted to approach 3:6:1. In addition, light emitting areas of the first, second, and third subunits 2, 3 and 4 may 10,000µm² or less, specifically 4,000µm² or less, more specifically 2,500µm² or less. In addition, the light emitting area of a subunit may be larger as the subunit is closer to the substrate 11, and the luminous intensity of green light may be further increased by arranging the third subunit 4 emitting green light closest to the substrate 11. Although the light emitting device 100 is illustrated as including three subunits 2, 3 and 4, but the inventive concepts are not limited to a specific number of subunits. For example, the light emitting device may include two or more subunits in some embodiments. Herein, the light emitting device 100 including three subunits 2, 3, and 4 according to an embodiment will be exemplarily described.

In the following description, the second subunit 3 emitting light of a wavelength shorter than that of the third subunit 4, for example, blue light, will be exemplarily described, but it should be noted that the second subunit 3 may emit light of a wavelength longer than that of the third subunit 4, for example, green light.

The first subunit 2 may include a first LED stack 20 and a first upper contact electrode 25p, and may further include a first lower contact electrode 21n.

The first LED stack 20 may include a first conductivity type semiconductor layer 21, an active layer 23, and a second conductivity type semiconductor layer 25. According to an embodiment, the first LED stack 20 may include, for example, a semiconductor material emitting red light, such as AlGaAs, GaAsP, AlGaInP, and GaP, without being limited thereto.

The first upper contact electrode 25p is in ohmic contact with the second conductivity type semiconductor layer 25. The first upper contact electrode 25p may be formed of, for example, a transparent conductive oxide such as indium tin oxide (ITO), without being limited thereto, and for example, it may be formed of a metallic layer capable of being in ohmic contact with the second conductivity type semiconductor layer 25. The first upper contact electrode 25p may be formed of, for example, ITO with a thickness of 200nm to 400nm.

The first lower contact electrode 21n may be disposed on the first conductivity type semiconductor layer 21, and may be in ohmic contact with the first conductivity type semiconductor layer 21. The first upper contact electrode 25p, the active layer 23, and the second conductivity type semiconductor layer 25 may be patterned, and thus, an upper surface of the first conductivity type semiconductor layer 21 may be exposed. The first lower contact electrode 21n may be formed on the exposed first conductivity type semiconductor layer 21.

The first lower contact electrode 21n may have a single-layer structure or a multi-layer structure, and may include Al, Ti, Cr, Ni, Au, Ag, Sn, W, Cu, or an alloy thereof, such as Au-Te alloy or an Au-Ge alloy, without being limited thereto.

In this embodiment, the first conductivity type semiconductor layer 21 may be disposed closer to the substrate 11 than the second conductivity type semiconductor layer 25. Light generated in the active layer 23 may be emitted toward the substrate 11 through the first conductivity type semiconductor layer 21. Since light generated in the first subunit 2 is emitted to the outside through the second subunit 3 and the third subunit 4, light loss may occur. In this embodiment, the first conductivity type semiconductor layer 21 may include a roughened surface 21r, and an extraction efficiency of light generated in the active layer 23 may be increased by the roughened surface 21r. A depth D of a concave portion of the roughened surface 21r may be in a range of about 0.1µm to 0.9µm. The roughened surface 21r may be disposed toward the substrate 11, and may contact an adhesive 61. The roughened surface 21r may be formed through wet or dry etching, and a side inclination angle of a protruding portion or the concave portion may be within a range of 35 degrees to 65 degrees. The roughened surface 21r may be a micro-optic. Accordingly, when light generated in the first subunit 2 is directed to the second subunit 3, it may be focused upward by the micro-optic. The micro-optic may have an irregular shape, or may have a regular shape. The adhesive 61 may be filled in a depth region of the micro-optic. The adhesive 61 may have a refractive index different from that of the micro-optic. Therefore, the light extraction efficiency may be improved by increasing a surface area where the micro-optic is in contact with a material having a different refractive index. In addition, as the adhesive fills the depth region of the micro-optic, regions of different heights are generated. Accordingly, since the adhesive also serves as the micro-optic, it may be effective in light extraction. Materials of an upper surface and a lower surface of an interface of the micro-optic may be different from each other, and may have different refractive indices from each other. That is, the interface of the micro-optic may be disposed to be buried by the materials disposed on upper and lower portions.

In cross section view, a width W2 of a region where the micro-optic is formed may be greater than a width W1 of the first upper contact electrode 25p. In this case, the region where the micro-optic is formed includes a plurality of concavo-convex portions. In addition, the width W2 of the region where the micro-optic is formed may be smaller than a maximum width W3 of a second LED stack 30. Accordingly, light emitted through the micro-optic may be made to be incident toward the second LED stack 30 as much as possible.

In addition, although it will be described later, a second insulation layer 83 may include a distributed Bragg reflector (DBR), and by using the second insulation layer 83 to reflect light generated in the active layer 23, a luminance of light emission of the subunit 2 may be increased. The DBR of the second insulation layer 83 may be formed to have a high reflectance of about 80% or more for light in the wavelength range of 600nm to 650nm.

The second subunit 3 may include the second LED stack 30 and a second lower contact electrode 35p, and may further include a second upper contact electrode 31n.

The second LED stack 30 may include a first conductivity type semiconductor layer 31, an active layer 33, and a second conductivity type semiconductor layer 35. In an embodiment, the second LED stack 30 may include a semiconductor material emitting blue light, such as GaN, InGaN, ZnSe, or the like, without being limited thereto. The second lower contact electrode 35p may be disposed under the second conductivity type semiconductor layer 35 of the second LED stack 30, and may be in ohmic contact with the second conductivity type semiconductor layer 35. The second lower contact electrode 35p may be formed of a material transparent to light generated in the first subunit 2 and the third subunit 3, for example, red light and blue light, and may be formed of, for example, a transparent conductive oxide such as ITO or ZnO. The second lower contact electrode 35p may be formed of, for example, ITO with a thickness of 200nm to 400nm.

In this embodiment, the first conductivity type semiconductor layer 31 of the second LED stack 30 may be disposed to face the first conductivity type semiconductor layer 21 of the first LED stack 20. Accordingly, regardless of the active layer 33 and the second conductivity type semiconductor layer 35, an upper surface of the first conductivity type semiconductor layer 31 may be exposed, and the second upper contact electrode 31n may be formed on the exposed surface of the first conductivity type semiconductor layer 31. The second upper contact electrode 31n may be omitted.

The third subunit 4 may include the third LED stack 40 and a third upper contact electrode 45p, and may further include a third lower contact electrode 41n.

The third LED stack 40 may include a first conductivity type semiconductor layer 41, an active layer 43, and a second conductivity type semiconductor layer 45. In an embodiment, the third LED stack 40 may include a semiconductor material emitting green light, such as GaN, InGaN, GaP, AlGaInP, AlGaP, or the like. The third upper contact electrode 45p may be disposed on the second conductivity type semiconductor layer 45 of the third LED stack 40, and may be in ohmic contact with the second conductivity type semiconductor layer 45. The third upper contact electrode 45p may be formed of a material transparent to light generated in the first subunit 2 and the third subunit 3, for example, red light and blue light, and may be formed of, for example, a transparent conductive oxide such as ITO or ZnO. The third upper contact electrode 45p may be formed of, for example, ITO with a thickness of 200nm to 400nm.

In this embodiment, the second conductivity type semiconductor layer 45 of the third LED stack 40 faces the second conductivity type semiconductor layer 35 of the second LED stack 30. That is, the second LED stack 30 and the third LED stack 40 are disposed such that the second conductivity type semiconductor layers 35 and 45 having a same polarity face each other. In the second LED stack 30 and the first LED stack 20, the first conductivity type semiconductor layers 21 and 31 having the same polarity are also disposed to face each other.

According to embodiments of the present disclosure, each of the first conductivity type semiconductor layers 21, 31, and 41 and the second conductivity type semiconductor layers 25, 35, and 45 of the first, second, and third LED stacks 20, 30, and 40 may have a single-layer structure or a multi-layer structure, and in some embodiments, may include a superlattice layer. In addition, the active layers 23, 33, and 43 of the first, second, and third LED stacks 20, 30, and 40 may have a single quantum well structure or a multiple quantum well structure.

A total thickness from the first subunit 2 to the third subunit 4 including the first, second, and third LED stacks 20, 30, and 40 may be, for example, about 10µm to about 30µm.

Preferably, it may be about 15µm to about 25µm, more preferably, it may be about 18µm to about 22µm, but the inventive concepts are not limited thereto. In general, the substrate 11 may be thicker than the total thickness of the first, second, and third subunits 2, 3, and 4. In an embodiment, a ratio of the thickness of the substrate 11 to the thickness of the first, second, and third subunits 2, 3 and 4 may be in a range of 1.5:1 to 6:1, further, 1.5:1 to 4:1, and furthermore, 2.27:1 to 2.78:1. As the thickness ratio decreases, that is, as the thickness of the substrate 11 relative to the thickness of the first, second, and third subunits 2, 3, and 4 decreases, for a light amount emitted to the outside of the light emitting device 100, a ratio of a light amount extracted to the side surface of the substrate 11 decreases, and a ratio of a light amount extracted in the direction perpendicular to the rear surface of the substrate 11 through the substrate 11 increases. Accordingly, a color difference according to a viewing angle may be alleviated by reducing a difference in radiation patterns of light extracted from the light emitting device 100.

The thickness of the substrate 11 may be greater than the thickness including the first, second, and third LED stacks 20, 30, and 40, or may be greater than a thickness of a partial region of the protection layer 90 disposed between the connection electrodes 20ce, 30ce, 40ce, and 50ce and formed in a region vertically overlapping with the first, second, and third LED stacks 20, 30, and 40. In addition, it may be smaller than a thickness of a portion of the protection layer 90 surrounding outermost side surfaces of the connection electrodes 20ce, 30ce, 40ce, and 50ce. Through this, it is possible to effectively reduce a light deviation according to a viewing angle.

Each of the first upper contact electrode 25p, the second lower contact electrode 35p, and the third upper contact electrode 45p may include a transparent conductive material that transmits light. For example, the contact electrodes 25p, 35p, and 45p may be a transparent conductive oxide (TCO), and the transparent conductive oxide (TCO) may include SnO, InO₂, ZnO, ITO, ITZO, or the like, but the inventive concepts are not limited thereto.

A first adhesive layer 61 may be disposed between the first LED stack 20 and the second LED stack 30, and a second adhesive layer 63 may be disposed between the second LED stack 30 and the third LED stack 40. The first adhesive layer 61 may contact the first conductivity type semiconductor layer 21 of the first LED stack 20 and the first conductivity type semiconductor layer 31 of the second LED stack 30. The first adhesive layer 61 may include regions having different thicknesses from each other, that is, a thick region and a thin region. A thickness of the second adhesive layer 63 may be smaller than a maximum thickness of the thick region of the first adhesive layer 61 and greater than a minimum thickness of the thin region of the first adhesive layer 61. The second adhesive layer 63 may be formed to have a thickness within a range of 1.8µm to 2.2µm, for example. The first and second adhesive layers 61 and 63 may include a non-conductive material that transmits light. For example, the first and second adhesive layers 61 and 63 may include an optically clear adhesive (OCA), and may include, for example, epoxy, silicone, polyimide, SU8, spin-on- Glass (SOG) and benzocyclobutene (BCB), but the inventive concepts are not limited thereto. The first adhesive layer 61 and the second adhesive layer 63 do not have to be identical to each other, and may be formed of different materials from each other, for example, materials having different refractive indices, melting points, or transmittances.

A first stress relief layer 51 may be disposed on an upper surface of the second adhesive layer 63, and may be positioned between the second adhesive layer 63 and the second LED stack 30. A second stress relief layer 53 may be disposed on a lower surface of the second adhesive layer 63, and may be positioned between the second adhesive layer 63 and the third LED stack 40. Each of the first and second stress relief layers 51 and 53 may be formed to have a thickness of, for example, 50nm to 150nm. The first and second stress relief layers 51 and 53 may include an insulating material. For example, the first and second stress relief layers 51 and 53 may include organic or inorganic insulating materials such as polyimide, SiO₂, SiNx, Al₂O₃, and the like, and for example, may be SiO₂, but the inventive concepts are not limited thereto.

The first and second stress relief layers 51 and 53 may be disposed between the LED stacks when the first, second, and third LED stacks 20, 30, and 40 are arranged to vertically overlap with one another. More specifically, in a process of sequentially bonding the second LED stack 30 and the first LED stack 20 on the third LED stack 40, warpage of the substrate 11 may occur, and as a result, cracks may occur between the LED stacks 20, 30, and 40. The first and second stress relief layers 51 and 53 disposed between the LED stacks 20, 30, and 40 may relieve the warpage of the substrate 11, and thus, defects such as cracks that may occur between the LED stacks 20, 30, and 40 may be prevented.

A first insulation layer 81 and a second insulation layer 83 may be disposed on at least portions of upper and side surfaces of the first, second, and third LED stacks 20, 30, and 40.

At least one of the first and second insulation layers 81 and 83 may include various organic or inorganic insulating materials such as polyimide, SiO2, SiNx, Al2O3, and the like. In addition, at least one of the first and second insulation layers 81 and 83 may have a single-layer structure or a multi-layer structure, and an example of the multi-layer structure may include a distributed Bragg reflector (DBR). In an embodiment, the first insulation layer 81 may be formed of SiO₂, and the second insulation layer 83 may be formed of a distributed Bragg reflector (DBR). The first insulation layer 81 may be thinner than the second insulation layer 83, and for example, it may have a thickness of about 0.4µm. The second insulation layer 83 may have a thickness of about 1.5µm to about 3µm.

The distributed Bragg reflector DBR of the second insulation layer 83 may include a first material layer having a first refractive index and a second material layer having a second refractive index. The first material layer may have a lower refractive index, and the second material layer may have a higher refractive index. The "lower refractive index" and the "higher refractive index" refer to a relative difference in refractive indices comparing those of the first material layer and the second material layer. In an embodiment, the first material layers may be SiO₂, and the second material layers may be TiO₂. The refractive index of SiO₂ of the first material layer is about 1.47, and the refractive index of TiO₂ is about 2.41. However, in the present disclosure, the first material layer and the second material layer are not limited to SiO₂ and TiO₂, and for example, the first and second material layers may be formed of Si₃N₄, MgF₂, Nb₂O₅, ZnS, ZrO2, ZnO or a compound semiconductor or the like. However, the difference in refractive indices between the first material layer and the second material layer may be greater than 0.5.

The distributed Bragg reflector DBR may be formed by repeatedly stacking pairs of the first material layer and the second material layer a plurality of times. In general, material layers having a higher refractive index have a higher absorption rate than material layers having a lower refractive index. Therefore, controlling optical thicknesses of the second material layers having a higher refractive index to be smaller than optical thicknesses of the first material layers having a lower refractive index may reduce loss due to light absorption. Accordingly, each thickness of SiO₂ which is the first material layer may be formed to be thicker than each thickness of TiO₂ which is the second material layer.

The first material layers forming the distributed Bragg reflector (DBR) may be formed such that at least two layers have different thicknesses. Alternatively, the second material layers forming the distributed Bragg reflector (DBR) may be formed such that at least two layers have different thicknesses. Since the distributed Bragg reflector (DBR) have to function optically for different peak wavelengths generated in each of the LED stacks 20, 30, and 40, the first material layer or the second material layer may improve optical functions such as light reflection or light path change for a plurality of peak wavelength by forming at least two layers with different thicknesses.

In addition, a first layer and a last layer of the distributed Bragg reflector (DBR) may be SiO₂. By using the SiO₂ as the first layer of the distributed Bragg reflector (DBR), an adhesion with the first insulation layer 81 may be enhanced, and by using SiO₂ which is the last layer, the distributed Bragg reflector (DBR) may be protected, and adhesions of the protection layer 90 and the connection electrodes 20ce, 30ce, 40ce, and 50ce which will be described later may be enhanced.

According to an embodiment, the distributed Bragg reflector (DBR) applied to the second insulation layer 83 may have a reflectance of 80% or more, further, 90% or more, and furthermore, 95% or more over the wavelength range of 600nm to 650nm, and thus, light emitted and incident from the light emitting device 100, in particular, from the first subunit 2, may be reflected with a high reflectance. The distributed Bragg reflector (DBR) may include, for example, 16 to 25 pairs of the first material layer and the second material layer, without being limited thereto. The distributed Bragg reflector may have a thickness of about 1.5µm to about 3µm. The distributed Bragg reflector (DBR) may exhibit a reflectance of 90% or more over a wavelength range of 410nm to 700nm. A partial region of the second insulation layer 83 may contact the first insulation layer 81, and another partial region may contact a first pad electrode 20pd. The second insulation layer 83 may be formed to extend over the first conductivity type semiconductor layer 41 of the third LED stack 40. In addition, outer side surfaces of the second insulation layer 83 may have a side surface in flush with a side surface of the first conductivity type semiconductor layer 41 of the third LED stack 40. Alternatively, the second insulation layer 83 may be formed to extend to an upper surface of the substrate 11. In addition, the outer side surfaces of the second insulation layer 83 may have a side surface in flush with a side surface of the substrate 11. Therefore, a region where the second insulation layer 83 reflects light may be increased, and light entering an adjacent pixel may be effectively blocked. In another embodiment, a portion of the second insulation layer 83 may contact the upper surface of the substrate 11.

The second insulation layer 83 may improve a light extraction efficiency by reflecting light emitted from the first, second, and third LED stacks 20, 30, and 40. In addition, the multilayer distributed Bragg reflector (DBR) may improve straightness of extracted light through formation of an optical cavity, and may reduce a deviation of radiation patterns of blue light, green light, and red light to mitigate a color difference according to viewing angles.

The first insulation layer 81 may be etched to form contact holes 20CH, 30CH, 40CH, and SOCH which will be described later. Since the first insulation layer 81 is formed of a SiO₂ single layer, an etching process may be smoothly performed. Accordingly, it is possible to secure a uniform etching thickness without damaging underlying lower contact electrodes 25p, 35p, and 45p, and thus, it is possible to allow to maintain stable electrical characteristics of the device. In addition, the distributed Bragg reflector (DBR) of the second insulation layer 83 may improve light extraction efficiency by inducing diffuse reflection of light extracted from the side surfaces of the first, second, and third subunits 2, 3, and 4.

When the first insulation layer 81 is formed of a dielectric layer having a low refractive index such as SiO₂, the first insulation layer 81 may constitute an omni-directional reflector together with the first through third LED stacks 20, 30, and 40 and electrode pads 20pd, 30pd, 40pd, and 50pd.

Each of the first, second, and third LED stacks 20, 30, and 40 may be driven independently. In an embodiment, a common voltage may be applied to the first conductivity type semiconductor layers 21, 31, and 41 of the first, second, and third LED stacks 20, 30, and 40, and an individual emission signal may be applied to each of the second conductivity type semiconductor layers 25, 35, and 45. In another embodiment, an individual emission signal may be applied to each of the first conductivity type semiconductor layers 21, 31, and 41 of the first, second, and third LED stacks 20, 30, and 40, and a common voltage may be applied to the second conductivity type semiconductor layers 25, 35, and 45. For example, the first conductivity type semiconductor layers 21, 31, and 41 of each of the LED stacks 20, 30, and 40 may be an n-type, and the second conductivity type semiconductor layers 25, 35, and 45 may be a p-type. In this case, a common voltage may be applied to the first conductivity type semiconductor layers 21, 31, and 41, and an individual emission signal may be applied to each of the second conductivity type semiconductor layers 25, 35, and 45, or vice versa. When the first, second, and third LED stacks 20, 30, and 40 are vertically stacked, the third LED stack 40 may have an opposite stacking sequence compared to those of the first and second LED stacks 20 and 30. That is, the second conductivity type semiconductor layer 45 of the third LED stack 40, for example, the p-type semiconductor layer 45 may be disposed over the active layer 43, and the second conductivity type semiconductor layer 35 of the second LED stack 30 may be disposed under the active layer 33. A manufacturing process of the light emitting device 100 may be simplified by making the stacking sequence of the third LED stack 40 opposite to the stacking sequence of the second LED stack 30. In this embodiment, it has been described that the first conductivity type semiconductor layer and the second conductivity type semiconductor layer are the n-type and the p-type, respectively, but inventive concepts are not limited thereto, or vice versa.

According to the illustrated embodiment, the light emitting device 100 may include a first pad electrode 20pd, a second pad electrode 30pd, a third pad electrode 40pd, and a fourth pad electrode 50pd. The second conductivity type semiconductor layers 25, 35, and 45 of the LED stacks 20, 30, and 40 may be respectively connected to the first electrode pad 20pd, the second electrode pad 30pd, and the third electrode pad 40pd to receive a corresponding light emitting signal, respectively. Meanwhile, the first conductivity type semiconductor layers 21, 31, and 41 of the LED stacks 20, 30, and 40 may be connected to the fourth pad electrode 50pd to receive a common voltage from the outside. In this way, each of the first, second, and third LED stacks 20, 30, and 40 may be driven independently while having a common n-type electrode to which a common voltage is applied, but the inventive concepts are not limited thereto.

The first electrode pad 20pd may be connected to the first upper contact electrode 25p through a first contact hole 20CH defined through the first insulation layer 81, and may also be electrically connected to the second conductivity type semiconductor layer 25. The first electrode pad 20pd may be disposed between the first insulation layer 81 and the second insulation layer 83 to have a region at least partially overlapping with them.

The second electrode pad 30pd may be connected to the second lower contact electrode 35p through a second contact hole 30CH defined through the first insulation layer 81, and may also be electrically connected to the second conductivity type semiconductor layer 35. The second electrode pad 30pd may be disposed between the first insulation layer 81 and the second insulation layer 83 to have a region at least partially overlapping with them.

The third electrode pad 40pd may be connected to the third upper contact electrode 45p through a third contact hole 40CH defined through the first insulation layer 81, and may also be electrically connected to the second conductivity type semiconductor layer 45. The third electrode pad 40pd may be disposed between the first insulation layer 81 and the second insulation layer 83 to have a region at least partially overlapping with them.

The fourth electrode pad 50pd is commonly electrically connected to the first conductivity type semiconductor layers 21, 31, and 41 of the first, second, and third LED stacks 20, 30, and 40. For example, the fourth electrode pad 50pd may be electrically connected to the first lower contact electrode 21n, the second upper contact electrode 31n, and the third lower contact electrode 41n disposed on the first conductivity type semiconductor layers 21, 31, and 41 of the first, second, and third LED stacks 20, 30, and 40 through a first sub contact hole 50CHa, a second sub contact hole 50CHb, and a third sub contact hole 50CHc defined through the first insulation layer 81. At least one of the first lower contact electrode 21n, the second upper contact electrode 31n, the third lower contact electrode 41n may be omitted, and the fourth electrode pad 50pd may be directly electrically connected to the first conductivity type semiconductor layer 21 of the first LED stack 20, and may be directly electrically connected to the first conductivity type semiconductor layer 31 of the second LED stack 30 through the second sub contact hole 50CHb, or may be directly electrically connected to the first conductivity type semiconductor layer 41 of the third LED stack 40 through the third sub contact hole 50CHc.

According to an embodiment of the present disclosure, the electrode pads 20pd, 30pd, 40pd, and 50pd may be formed in various locations. For example, as shown in FIG. 1A, when the upper surface of the light emitting device 100 is a rectangle, the electrode pads 20pd, 30pd, 40pd, and 50pd may be disposed around each vertex of the rectangle. However, the inventive concepts are not limited thereto, and the light emitting device 100 may be formed in various shapes, and the electrode pads 20pd, 30pd, 40pd, and 50pd may be formed in various locations according to the shape of the light emitting device.

The first, second, third, and fourth electrode pads 20pd, 30pd, 40pd, and 50pd may be spaced apart and insulated from one another. According to an embodiment of the present disclosure, each of the first, second, third, and fourth electrode pads 20pd, 30pd, 40pd, and 50pd may cover at least portions of side surfaces of the first, second, and third LED stacks 20, 30, and 40.

The first through fourth connection electrodes 20ce, 30ce, 40ce, and 50ce may be formed in an elongated shape in a vertical direction from the substrate 11. That is, in cross section view, a ratio of a maximum width W4 in a lateral direction to a maximum length H1 in a vertical direction of the first through fourth connection electrodes 20ce, 30ce, 40ce, and 50ce may be a: b, where a may be greater than 0, and a<b. The first connection electrode 20ce may be electrically connected to the first electrode pad 20pd through a first through-hole 20ct defined through the second insulation layer 83. The second connection electrode 30ce may be electrically connected to the second electrode pad 30pd through a second through-hole 30ct defined through the second insulation layer 83. The third connection electrode 40ce may be electrically connected to the third electrode pad 40pd through a third through-hole 40ct defined through the second insulation layer 83. The fourth connection electrode 50ce may be electrically connected to the fourth electrode pad 50pd through a fourth through-hole 50ct defined through the second insulation layer 83.

The first through fourth connection electrodes 20ce, 30ce, 40ce, and 50ce may include a metal such as Cu, Ni, Ti, Sb, Mo, Co, Sn, Ag, or an alloy thereof, without being limited thereto. For example, each of the first through fourth connection electrodes 20ce, 30ce, 40ce, and 50ce may include two or more metals or a plurality of different metallic layers to reduce stress due to the elongated shapes of the first through fourth connection electrodes 20ce, 30ce, 40ce, and 50ce. When the first through fourth connection electrodes 20ce, 30ce, 40ce, and 50ce include Cu, an additional metal may be formed to suppress oxidation of the Cu. In addition, the first through fourth connection electrodes 20ce, 30ce, 40ce, and 50ce may include Cu/Ni/Sn, and in this case, Cu may prevent Sn from infiltrating into the light emitting device 100, and Cu also has favorable thermal conductivity, and thus, heat generated from the light emitting device 100 may be easily spread to the outside.

The first through fourth connection electrodes 20ce, 30ce, 40ce, and 50ce may further include seed layers for forming a metallic layer in a plating process. The seed layers may be formed of a plurality of Ti/Cu layers, for example.

The first through fourth connection electrodes 20ce, 30ce, 40ce, and 50ce may have a flat upper surface, and thus, electrical connection between external lines or circuit electrodes described later and the first, second, and third LED stacks may be facilitated. According to an embodiment, when the light emitting device 100 includes a micro LED having a surface area of less than 10,000 µm², more specifically less than 4,000 µm² or 2,500 µm², the first through fourth connection electrodes 20ce, 30ce, 40ce, and 50ce may overlap with a portion of at least one of the first, second, and third LED stacks 20, 30, and 40. More specifically, the first through fourth connection electrodes 20ce, 30ce, 40ce, and 50ce may overlap with at least one step formed on the side surfaces of the first, second, and third LED stacks 20, 30, and 40. As such, since contact areas of lower surfaces of the first through fourth connection electrodes 20ce, 30ce, 40ce, and 50ce are larger than those of upper surfaces thereof, a larger contact area may be formed between the first through fourth connection electrodes 20ce, 30ce, 40ce, and 50ce and the first, second, and third LED stacks 20, 30, and 40. Accordingly, the first through fourth connection electrodes 20ce, 30ce, 40ce, and 50ce may be more stably formed on the first, second, and third subunits 2, 3, and 4. In addition, the connection electrodes 20ce, 30ce, 40ce, and 50ce connected to the electrode pads 20pd, 30pd, 40pd, and 50pd occupy most of the area of the light emitting device 100, and thus, it is possible to provide a favorable light emitting device to dissipate generated heat. The connection electrodes 20ce, 30ce, 40ce, and 50ce may also efficiently dissipate the heat generated from the light emitting device 100 to the outside through a shortest path.

According to an embodiment, the protection layer 90 may be formed on the first, second, and third subunits 2, 3 and 4. More specifically, as shown in FIGs. 1B and 1C, the protection layer 90 may be formed between the first through fourth connection electrodes 20ce, 30ce, 40ce, and 50ce to cover at least portions of the side surfaces of the second and third subunits 2, 3, and 4 and side surfaces of the first through fourth connection electrodes 20ce, 30ce, 40ce, and 50ce. As illustrated, the protection layer 90 may expose side surfaces of the substrate 11, the first and second insulation layers 81 and 83, and the third LED stack 40. The protection layer 90 may be formed in flush with upper surfaces of the first through fourth connection electrodes 20ce, 30ce, 40ce, and 50ce, and may include an epoxy molding compound (EMC) or the like. The protection layer 90 may be transparent, or may be formed in various colors such as black, white, and others. The protection layer 90 may include polyimide (PID), and the polyimide (PID) may be provided as a dry film rather than a liquid form to increase flatness when applied to the first, second, and third subunits 2, 3, and 4. In addition, the protection layer 90 may include a photosensitive material. Accordingly, the protection layer 90 may not only protect the first, second, and third subunits 2, 3, and 4 from an external impact that may be applied during a subsequent process, but also provide a sufficient contact area for the light emitting device 100 to facilitate handling during a subsequent transferring step. In addition, the protection layer 90 may prevent or suppress interference of light emitted from adjacent light emitting devices 100 by preventing light leakage to the side surface of the light emitting device 100.

Protection metal layers 20ca, 30ca, 40ca, and 50ca may be further formed on the connection electrodes 20ce, 30ce, 40ce, and 50ce. The protection metal layers 20ca, 30ca, 40ca, and 50ca may be a plurality of multi-layered metallic layers, or may be Ti/Ni/Au, but the inventive concepts are not limited thereto. The protection metal layers 20ca, 30ca, 40ca, and 50ca may be formed on the upper surfaces of the first through fourth connection electrodes 20ce, 30ce, 40ce, and 50ce, and may be formed with widths smaller than those of the first through fourth connection electrodes 20ce, 30ce, 40ce, and 50ce. Accordingly, surface areas of the protection metal layers 20ca, 30ca, 40ca, and 50ca may be smaller than those of the first through fourth connection electrodes 20ce, 30ce, 40ce, and 50ce. However, the inventive concepts are not limited thereto, and the protection metal layers 20ca, 30ca, 40ca, and 50ca may be formed with widths greater than those of the first through fourth connection electrodes 20ce, 30ce, 40ce, and 50ce, and thus, larger surface areas may be formed.

A plurality of light emitting devices 100 may be formed by being arrayed on the substrate 11. The substrate 11 may be cut along a scribing line to be separated into each of the light emitting devices 100, and the light emitting devices 100 may be transferred to another substrate or a tape using various transferring techniques for subsequent processes such as packaging or modularization.

Hereinafter, a method of manufacturing the light emitting device 100 according to an embodiment of the present disclosure will be described. Details described in the above-described embodiment will be briefly described or omitted.

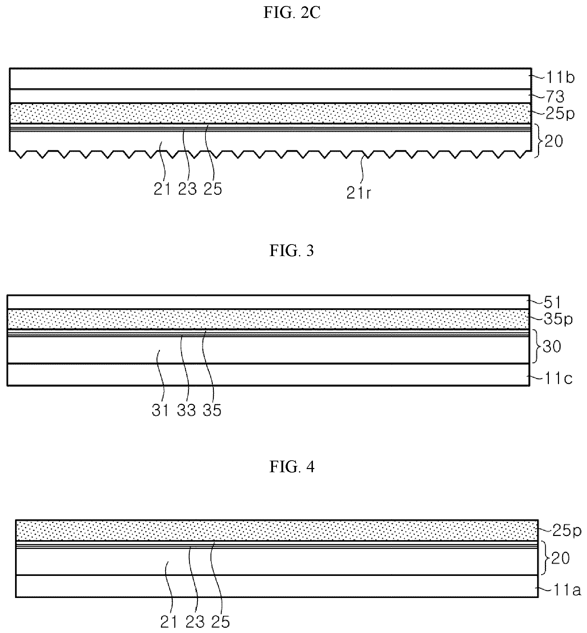

FIGs. 2A, 2B, and 2C are schematic cross-sectional views illustrating steps of providing a first LED stack according to an embodiment of the present disclosure, and FIG. 3 is a schematic cross-sectional view illustrating a step of providing a second LED stack according to an embodiment of the present disclosure, and FIG. 4 is a schematic cross-sectional view illustrating a step of providing a third LED stack according to an embodiment of the present disclosure.

First, referring to FIG. 2A, a first LED stack 20 including a first conductivity type semiconductor layer 21, an active layer 23, and a second conductivity type semiconductor layer 25 is grown on a substrate 11a. The substrate 11a may be, for example, a GaAs substrate. The first LED stack 20 may be grown by, for example, a metal organic chemical vapor deposition (MOCVD) method or a molecular beam epitaxy (MBE) method. A first upper contact electrode 25p may be formed on the second conductivity type semiconductor layer 25. The first upper contact electrode 25p may include a transparent conductive oxide (TCO) such as SnO, InO₂, ZnO, ITO, ITZO, and the like.

Referring to FIG. 2B, a carrier substrate 11b may be attached to the first upper contact electrode 25p using an adhesive 73. The carrier substrate 11b may be, for example, a sapphire substrate, without being limited thereto. After the carrier substrate 11b is attached, the substrate 11a may be removed. The substrate 11a may be removed using, for example, a wet etching technique. As the substrate 11a is removed, a lower surface of the first conductivity type semiconductor layer 21 may be exposed.

Referring to FIG. 2C, a roughened surface 21r may be formed by etching the lower surface of the first conductivity type semiconductor layer 21 using a wet or dry etching technique. As described with reference to FIG. 1B, a depth D of the roughened surface 21r may be in a range of about 0.1µm to about 0.9µm. The roughened surface 21r may be a micro-optic. Accordingly, when light generated in a first subunit 2 is directed to a second subunit 3, it may be focused upward by the micro-optic. The micro-optic may have an irregular shape, or may have a regular shape.

Meanwhile, referring to FIG. 3, a second LED stack 30 including a first conductivity type semiconductor layer 31, an active layer 33, and a second conductivity type semiconductor layer 35 is grown on a substrate 11c. The substrate 11c may be, for example, a sapphire substrate, without being limited thereto. The first conductivity type semiconductor layer 31, the active layer 33, and the second conductivity type semiconductor layer 35 may be sequentially grown on the substrate 11c by a metal organic chemical vapor deposition (MOCVD) method or a molecular beam epitaxy (MBE) method.

A second lower contact electrode 35p may be formed on the second conductivity type semiconductor layer 35. The second lower contact electrode 35p may be formed on the second conductivity type semiconductor layer 35 by a physical vapor deposition method or a chemical vapor deposition method. The second lower contact electrode 35p may include a transparent conductive oxide (TCO) such as SnO, InO₂, ZnO, ITO, ITZO, and the like. Furthermore, a first stress relief layer 51 may be formed on the second lower contact electrode 35p. The first stress relief layer 51 may be formed of, for example, SiO₂.

Referring to FIG. 4, a third LED stack 40 including a first conductivity type semiconductor layer 41, an active layer 43, and a second conductivity type semiconductor layer 45 may be grown on a substrate 11. The substrate 11 may be a sapphire substrate, without being limited thereto. The first conductivity type semiconductor layer 41, the active layer 43, and the second conductivity type semiconductor layer 45 may be grown on the substrate 11 by a metal organic chemical vapor deposition (MOCVD) method or a molecular beam epitaxy (MBE) method. A third upper contact electrode 45p may be formed on the second conductivity type semiconductor layer 45. The third upper contact electrode 45p may be formed on the second conductivity type semiconductor layer 45 by a physical vapor deposition method or a chemical vapor deposition method, and may include a transparent conductive oxide (TCO) such as SnO, InO₂, ZnO, ITO, ITZO, and the like. Furthermore, a second stress relief layer 53 may be formed on the third upper contact electrode 45p. The second stress relief layer 53 may be formed of, for example, SiO₂. Meanwhile, a second adhesive layer 63 may be formed on the second stress relief layer 53. According to an embodiment of the present disclosure, the third LED stack 40 may emit green light.

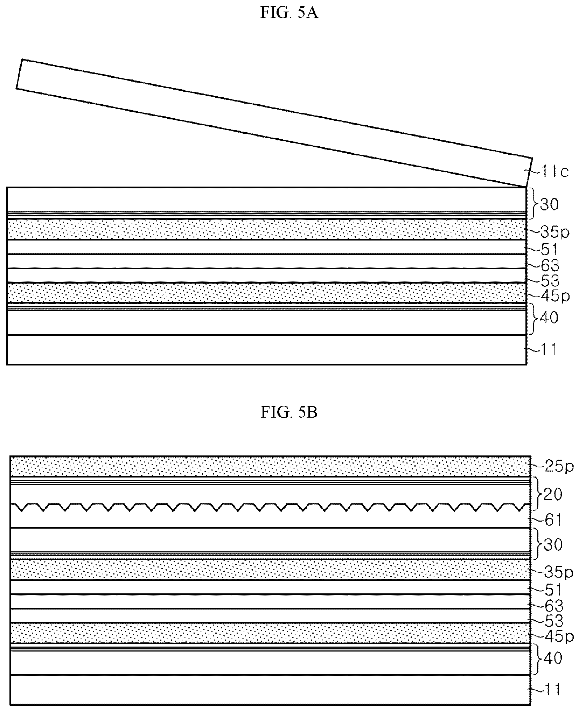

Referring to FIG. 5A, the second and third LED stacks 30 and 40 are coupled to each other with the second adhesive layer 63 interposed therebetween, and the substrate 11c on which the second LED stack 30 is grown may be removed by a laser lift-off process, a chemical process, a mechanical process, and the like. Accordingly, the second LED stack 30 and the third LED stack 40 are coupled such that second conductivity type semiconductor layer 35 of the second LED stack 30 faces the second conductivity type semiconductor layer 45 of the third LED stack 40.

Referring to FIG. 5B, the first LED stack 20 of FIG. 2C may be coupled with the second LED stack 30 with the first adhesive layer 61 interposed therebetween, and the substrate 11b to which the first LED stack 20 is attached may be removed from the first LED stack 20 together with the adhesive 73. Accordingly, the first LED stack 20 and the second LED stack 30 are coupled such that the first conductivity type semiconductor layer 21 of the first LED stack 20 faces the first conductivity type semiconductor layer 31 of the second LED stack 30.

While the LED stacks 20, 30, and 40 are bonded to one another, and the substrates 11b and 11c of the first and second LED stacks 20 and 30 are separated, warpage may occur in the substrate 11 due to a difference in thermal expansion coefficient, and as a result, cracks may occur between the LED stacks 20, 30, and 40. However, in this embodiment, by disposing the first and second stress relief layers 51 and 53 between the LED stacks 20, 30, and 40, a defect such as cracks of the LED stacks 20, 30, and 40 may be prevented from occurring.

Subsequently, the light emitting device 100 is manufactured using a coupling structure of the first LED stack 20, the second LED stack 30, and the third LED stack 40, and hereinafter, a method of manufacturing the light emitting device 100 will be described in detail.

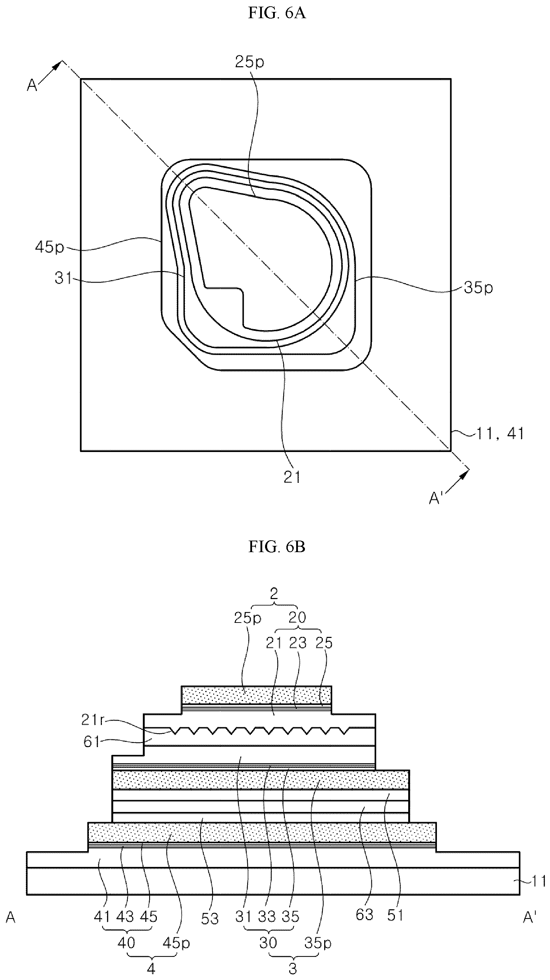

FIGs. 6A, 7A, 8A, 9A, and 10A are schematic plan views illustrating a method of manufacturing the light emitting device 100 according to an embodiment of the present disclosure. FIGs. 6B, 7B, 8B, 9B, and 10B are schematic cross-sectional views taken along line A-A' in FIGs. 6A, 7A, 8A, 9A, and 10A.

Referring to FIGs. 6A and 6B, various portions of the first, second, and third LED stacks 20, 30, and 40, the first upper contact electrode 25p, the second lower contact electrode 35p, and the third upper contact electrode 45p may be patterned through photolithography and etching processes, and together with an upper surface of the first upper contact electrode 25p, at least a portion of each of the first conductivity type semiconductor layer 21 of the first LED stack 20, the first conductivity type semiconductor layer 31 of the second LED stack 30, the second lower contact electrode 35p, the third upper contact electrode 45p, and the first conductivity type semiconductor layer 41 of the third LED stack 40 may be exposed. The first adhesive layer 61 may be patterned together with the first conductivity type semiconductor layer 21, and the first stress relief layer 51, the second adhesive layer 63, and the second stress relief layer 53 may be patterned together with the lower contact electrode 35p. However, the inventive concepts are not limited thereto. For example, the first stress relief layer 51, the second adhesive layer 63, and the second stress relief layer 53 may be patterned through a process separate from a patterning process of the second lower contact electrode 35p.

The first LED stack 20 may have a smallest area among the LED stacks 20, 30, and 40. Meanwhile, the third LED stack 40 may have a largest area among the LED stacks 20, 30, and 40, and thus, a luminous intensity of the third LED stack 40 may be relatively increased. However, the inventive concepts are not limited thereto, and relative sizes of the LED stacks 20, 30, and 40 are not particularly limited.

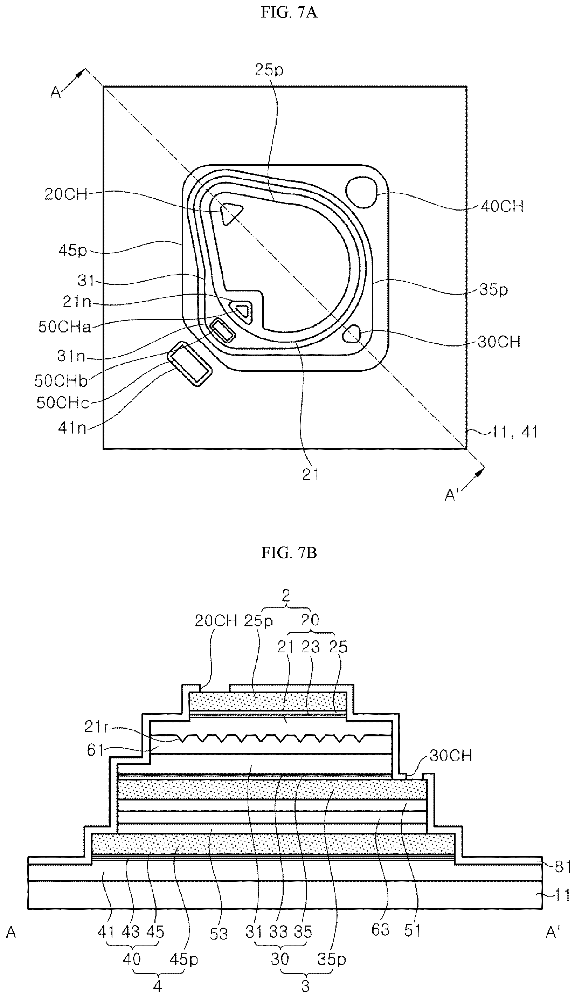

Referring to FIGs. 7A and 7B, a first lower contact electrode 21n, a second upper contact electrode 31n, and a third lower contact electrode 41n may be formed on the first conductivity type semiconductor layers 21, 31, and 41 of the first through third LED stacks 20, 30, and 40, respectively. The first lower contact electrode 21n, the second upper contact electrode 31n, and the third lower contact electrode 41n may be formed on exposed regions of each of the first conductivity type semiconductor layers 21, 31, and 41 to have a thickness of, for example, about 100nm, and may improve ohmic contact. At least one of the first lower contact electrode 21n, the second upper contact electrode 31n, and the third lower contact electrode 41n may be omitted. For example, the second upper contact electrode 31n and the third lower contact electrode 41n may be omitted.

After the first lower contact electrode 21n, the second upper contact electrode 31n, and the third lower contact electrode 41n are formed, a first insulation layer 81 may be formed. The first insulation layer 81 may be formed of, for example, SiO₂. The first insulation layer 81 may have a first, a second, and a third contact holes 20CH, 30CH, and 40CH exposing the first upper contact electrode 25p, the second lower contact electrode 35p, and the third upper contact electrode 45p, respectively, and fourth contact holes 50CHa, 50CHb, and 50CHc exposing the first lower contact electrode 21n, the second upper contact electrode 31n, and the third lower contact electrode 41n, respectively.

The first contact hole 20CH may be defined on the first upper contact electrode 25p to expose a portion of the first upper contact electrode 25p. The second contact hole 30CH may be defined on the second lower contact electrode 35p to expose a portion of the second lower contact electrode 35p. The third contact hole 40CH may be defined on the third upper contact electrode 45p to expose a portion of the third upper contact electrode 45p. The fourth contact holes 50CHa, 50CHb, and 50CHc may expose the first lower contact electrode 21n, the second upper contact electrode 31n, and the third lower contact electrode 41n disposed on respective first conductivity type semiconductor layers 21, 31, and 41 of the first, second, and third LED stacks 20, 30, and 40. When at least one of the first lower contact electrode 21n, the second upper contact electrode 31n, and the third lower contact electrode 41n is omitted, the fourth contact holes 50CHa, 50CHb, and 50CHc may expose portions of the first conductivity type semiconductor layers 21, 31, and 41.

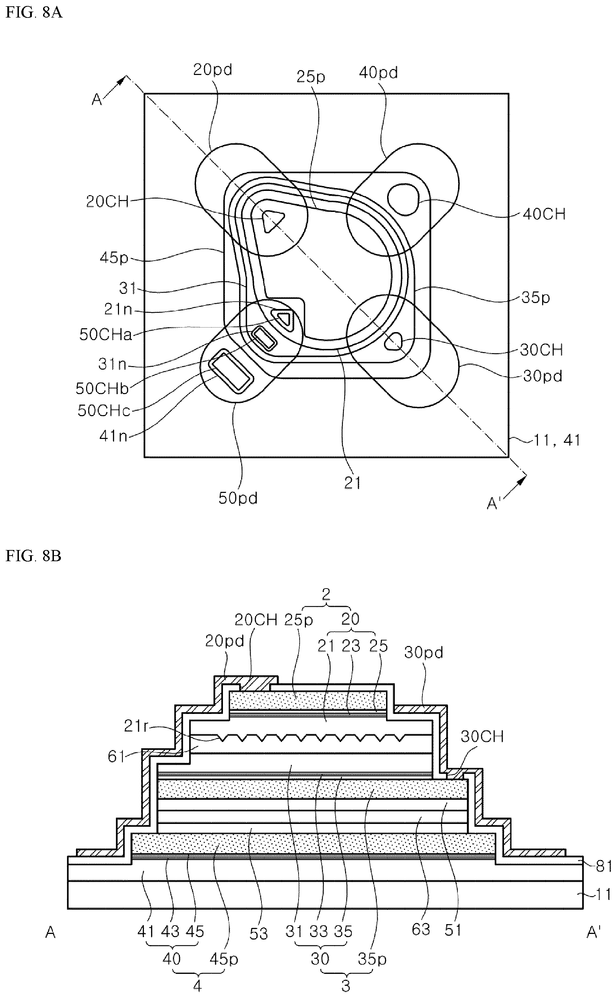

Referring to FIGs. 8A and 8B, first, second, third, and fourth electrode pads 20pd, 30pd, 40pd, and 50pd are formed on the first insulation layer 81. As shown in FIG. 8A, the first through fourth electrode pads 20pd, 30pd, 40pd, and 50pd may have an elongated shape in a diagonal direction, respectively, without being limited thereto. The first, second, third, and fourth electrode pads 20pd, 30pd, 40pd, and 50pd may be formed by forming a conductive layer on an entire surface of the substrate 11, and then patterning it using photolithography and etching processes or using a lift-off a process.

The first electrode pad 20pd may be electrically connected to the first upper contact electrode 25p through the first contact hole 20CH, and may be electrically connected to the second conductivity type semiconductor layer 25 through the first upper contact electrode 25p. The second electrode pad 30pd may be electrically connected to the second lower contact electrode 35p through the second contact hole 30CH, and may be electrically connected to the second conductivity type semiconductor layer 35 through the second lower contact electrode 35p. The third electrode pad 40pd may be connected to the third upper contact electrode 45p through the third contact hole 40CH, and may be electrically connected to the second conductivity type semiconductor layer 45 through the third upper contact electrode 45p. The fourth electrode pad 50pd may be commonly electrically connected to the first lower contact electrode 21n, the second upper contact electrode 31n, and the third upper contact electrode 41n through the fourth contact holes 50CHa, 50CHb, and 50CHc. The fourth electrode pad 50pd may be commonly electrically connected to the first conductivity type semiconductors 21, 31, and 41 of each of the first, second, and third LED stacks 20, 30, and 40.

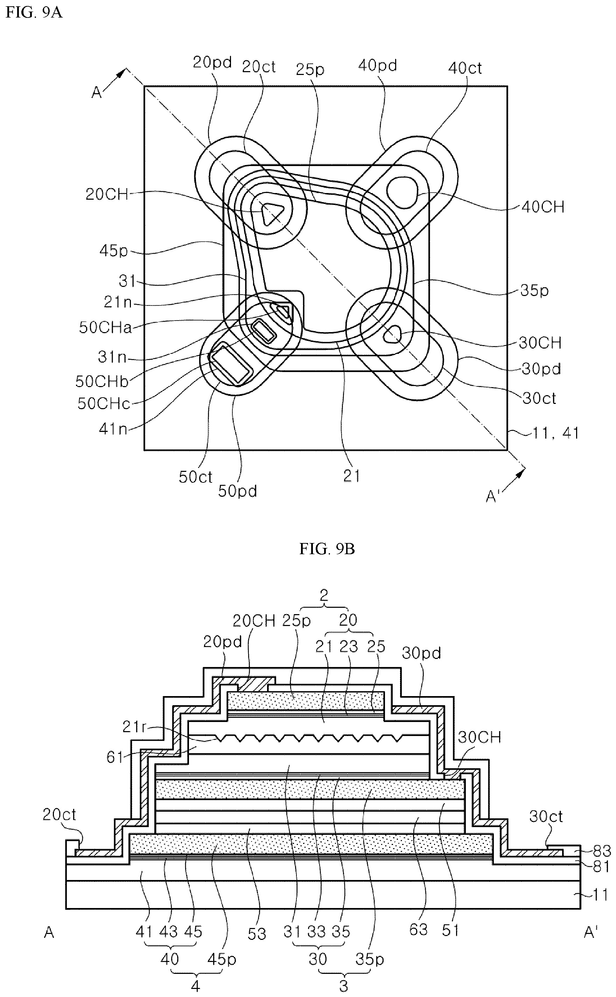

Referring to FIGs. 9A and 9B, a second insulation layer 83 may be formed on the first insulation layer 81. The second insulation layer 83 covers the first through fourth electrode pads 20pd, 30pd, 40pd, and 50pd, and has through-holes 20ct, 30ct, 40ct, and 50ct exposing them. The first insulation layer 81 may include a silicon oxide-based material, and the second insulation layer 83 may include a distributed Bragg reflector (DBR).

The first through-hole 20ct may be formed on the first electrode pad 20pd, and may expose at least a portion of the first electrode pad 20pd. The second through-hole 30ct may be formed on the second electrode pad 30pd, and may expose at least a portion of the second electrode pad 30pd. The third through-hole 40ct may be formed on the third electrode pad 40pd, and may expose at least a portion of the third electrode pad 40pd. The fourth through-hole 50ct may be formed on the fourth electrode pad 50pd, and may expose at least a portion of the fourth electrode pad 50pd. The first, second, third, and fourth through-holes 20ct, 30ct, 40ct, and 50ct may be defined within regions where the first, second, third, and fourth electrode pads 20pd, 30pd, 40pd, and 50pd are formed, respectively. The first, second, third, and fourth through-holes 20ct, 30ct, 40ct, and 50ct may have elongated shapes in a diagonal direction similar to those of the first through fourth electrode pads 20pd, 30pd, 40pd, and 50pd, without being limited thereto.

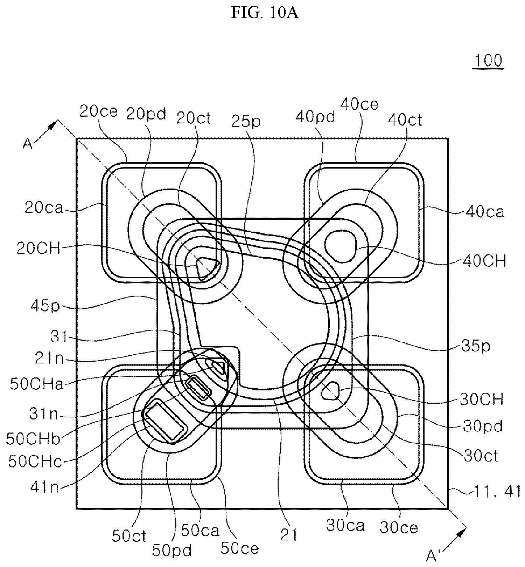

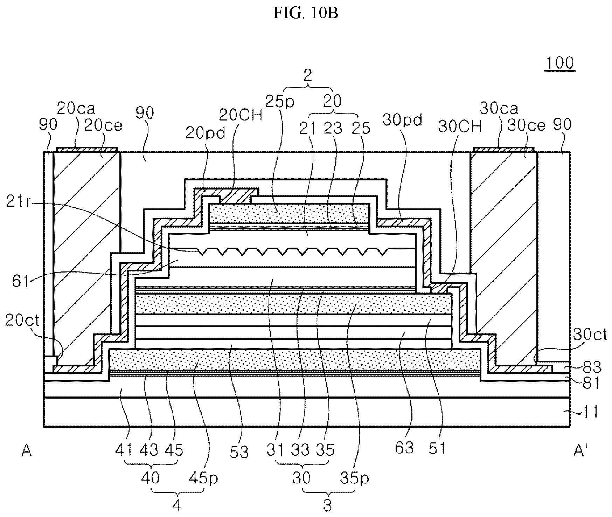

Referring to FIGs. 10A and 10B, first, second, third, and fourth connection electrodes 20ce, 30ce, 40ce, and 50ce may be formed on the second insulation layer 83. The first, second, third, and fourth connection electrodes 20ce, 30ce, 40ce, and 50ce may be respectively electrically connected to the first through fourth electrode pads 20pd, 30pd, 40pd, and 50pd exposed through the first through fourth through-holes 20ct, 30ct, 40ct, and 50ct. The first through fourth connection electrodes 20ce, 30ce, 40ce, and 50ce may be formed through electroplating using seed layers. The seed layers may be deposited to have a thickness of about 1,000Å, without being limited thereto. The seed layers may be formed of, for example, Ti/Cu. The first, second, third, and fourth connection electrodes 20ce, 30ce, 40ce, and 50ce may be plated with metals such as Cu, Ni, Ti, Sb, Zn, Mo, Co, Sn, Ag, or alloys thereof.

In addition, protection metal layers 20ca, 30ca, 40ca, and 50ca may be further disposed on the first, second, third, and fourth connection electrodes 20ce, 30ce, 40ce, and 50ce to prevent oxidation of the plating metal, and the protection metal layers 20ca, 30ca, 40ca, and 50ca may be deposited or plated on the plating metal using electroless nickel immersion gold (ENIG).

The first through fourth connection electrodes 20ce, 30ce, 40ce, and 50ce may have a vertically elongated shape on the substrate 11. In addition, the first through fourth connection electrodes 20ce, 30ce, 40ce, and 50ce may include two or more metals or a plurality of different metallic layers to reduce stress due to the elongated shape. However, the inventive concepts are not limited to specific shapes of the first through fourth connection electrodes 20ce, 30ce, 40ce, and 50ce.

Each of the first through fourth connection electrodes 20ce, 30ce, 40ce, and 50ce may have a flat upper surface to facilitate electrical connection between the first, second, and third subunits 2, 3, and 4 and external lines or electrodes. Accordingly, lower surfaces of the first through fourth connection electrodes 20ce, 30ce, 40ce, and 50ce may have surface areas larger than those of upper surfaces, and larger contact areas may be provided between the first through fourth connection electrodes 20ce, 30ce, 40ce, 50ce and the first, second, and third subunits 2, 3, and 4, and thus, a more stable structure that the first, second, and third subunits 2, 3, and 4 together with the protection layer 90 can withstand subsequent processes may be provided.

The protection layer 90 may be disposed between the first through fourth connection electrodes 20ce, 30ce, 40ce, and 50ce. The protection layer 90 may be formed in substantially flush with the upper surfaces of the first through fourth connection electrodes 20ce, 30ce, 40ce, and 50ce through a polishing process or the like. In an embodiment, the protection layer 90 may include black epoxy molding compound (EMC), or the like, without being limited thereto. For example, the protection layer 90 may include a photosensitive polyimide dry film (PID). Accordingly, the protection layer 90 may not only protect the first, second, and third subunits 2, 3, and 4 from an external impact that may be applied during a subsequent process, but also provide a sufficient contact area to the first, second, and third subunits 2, 3, and 4 to facilitate handling during a subsequent transferring step. In addition, the protection layer 90 may be transparent, or may have various colors such as black, white, and others, and may prevent light from leaking to the side surface of the light emitting device 100 to prevent or suppress interference of light emitted from an adjacent light emitting device 100.

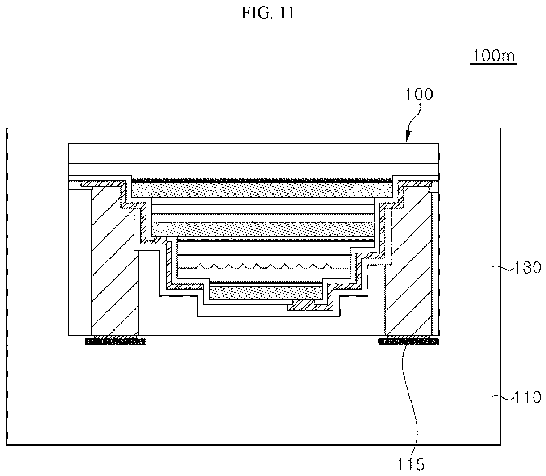

FIG. 11 is a schematic cross-sectional view illustrating a light emitting module 100m according to an embodiment of the present disclosure.

Referring to FIG. 11, the light emitting module 100m includes a circuit board 110 and a light emitting device 100. The circuit board 110 has pads 115 exposed on a surface thereof, and may also have interconnections connected inside or connected through a side surface. The circuit board 110 may be any material on which the light emitting device 100 can be mounted, such as a conductive circuit board, a printed circuit board, polyimide, or the like.

As described above, the light emitting device 100 may be flip-bonded to the pads 115 through the connection electrodes 20ce, 30ce, 40ce, and 50ce. A bonding agent such as solder or solder paste may be used to bond the light emitting device 100 and the circuit board 110. Light generated in the first through third subunits 2, 3, and 4 may ultimately be emitted to the outside through the substrate 11. The light emitting device 100 includes four connection electrodes 20ce, 30ce, 40ce, and 50ce, and thus, may be connected to four pads 115 on the circuit board 110. However, the inventive concepts are not limited thereto, and they may be connected by eutectic bonding, epoxy bonding, anisotropic conductive film (ACF) bonding, ball grid array (BGA), or the like.

Meanwhile, a molding member 130 may cover the light emitting device 100. The molding member 130 may transmit at least a portion of light emitted from the light emitting device 100, and may reflect, diffract, and absorb a portion of external light to prevent external light from being reflected by the light emitting device 100 in a direction visible to a user. The molding member 130 may cover at least a portion of the light emitting device 100 to protect the light emitting device 100 from moisture and an external impact. In addition, the molding member 130 may protect the light emitting module together with a protection layer 90 formed on the light emitting device 100. The molding member 130 may further include fillers such as silica, TiO₂, alumina, or the like. In addition, the molding member 130 may include a same material as that of the protection layer 90.

The molding member 130 may be formed through a method such as lamination or inkjet printing. For example, the molding member 130 is formed by a vacuum lamination process in which an organic polymer sheet is placed on the light emitting device 100 and high temperature and high pressure are applied in a vacuum, and thus, a flat upper surface of the light emitting module is provided, thereby improving light uniformity.

The molding member 130 may be formed to cover both an upper surface and side surfaces of the light emitting device 100. The molding member 130 may be formed of a transparent molding layer, or may be formed of a black matrix including a light absorbing material to prevent light diffusion.

In this embodiment, one light emitting device 100 is shown and described as being disposed on the circuit board 110, but the inventive concepts are not limited thereto. A plurality of light emitting devices 100 may be arranged on the circuit board 110. There is no particular limitation on the number of light emitting devices100 disposed on the circuit board 110. For example, the light emitting devices 100 may be arranged in a 2x2 arrangement on the circuit board 110, without being limited thereto, and may be arranged in various matrices (n × m, n=1,2,3,4,... , m=1,2,3,4,...). The circuit board 110 may include scan lines and data lines for independently driving each of the light emitting devices 100 included in the light emitting module 100m.

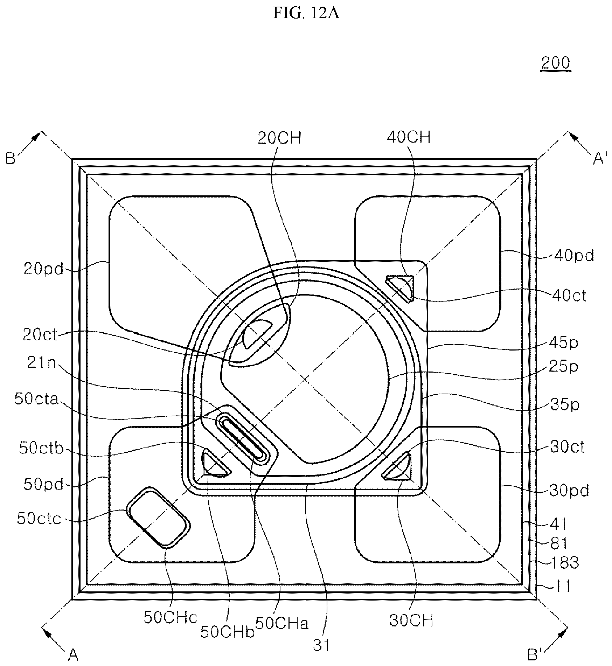

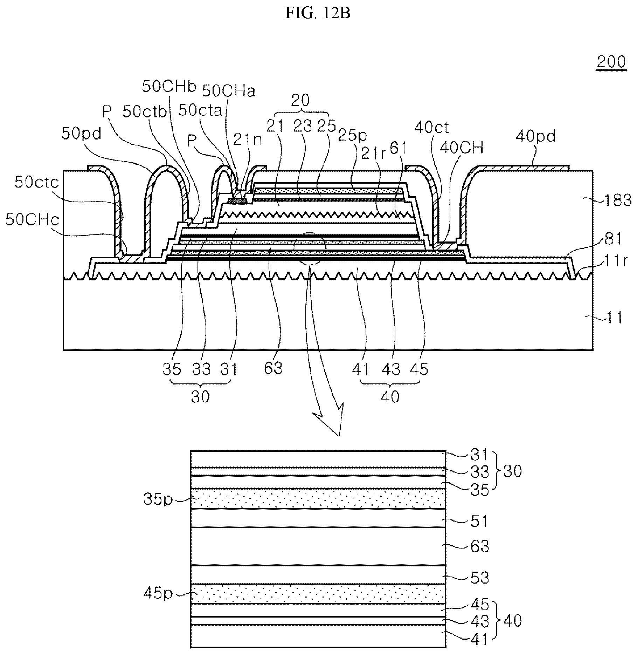

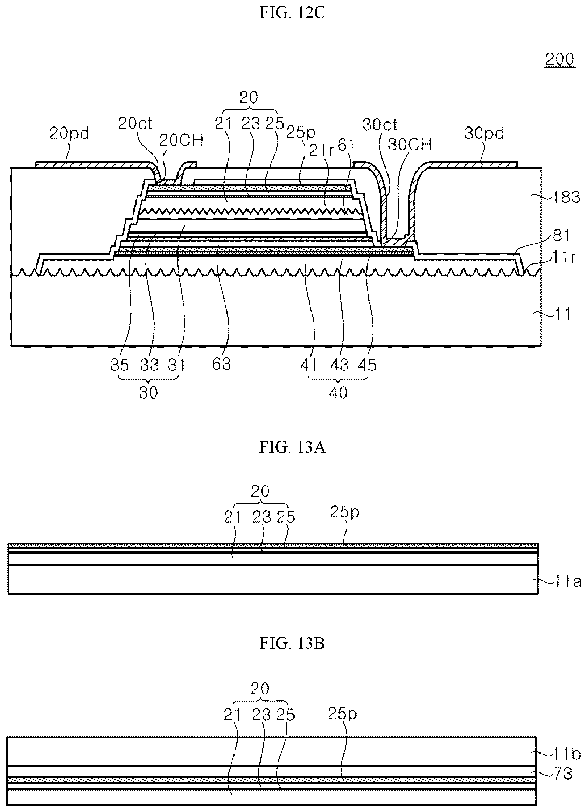

FIGs. 12A, 12B, and 12C are a schematic plan view and cross-sectional views illustrating a light emitting device 200 according to an embodiment of the present disclosure.

Referring to FIGs. 12A through 12C, the light emitting device 200 may include a substrate 11, first, second, and third LED stacks 20, 30, and 40, a lower insulation layer 81, an upper insulation layer 183, and first through fourth electrode pad layers 20pd, 30pd, 40pd, and 50pd. In addition, the light emitting device 200 may include an ohmic contact layer 21n, a first upper contact electrode 25p, a second lower contact electrode 35p, a third upper contact electrode 45p, a first adhesive layer 61, a second adhesive layer 63, and stress relief layers 51 and 53. The light emitting device 200 shown in FIG. 12A may be formed by singularizing a plurality of light emitting device arrays formed on the substrate 11. The light emitting device 200 may be mounted on a circuit board to form a light emitting module, which will be described in detail later.

The substrate 11 may include a light transmitting insulating material. The substrate 11 may be formed of a material capable of transmitting light in a visible light region, but the inventive concepts are not limited thereto. The substrate 11 may be formed to be translucent or partially transparent to transmit only light of a specific wavelength or only a portion of light of a specific wavelength. The substrate 11 may be a growth substrate capable of epitaxially growing the third LED stack 40, for example, a sapphire substrate. However, the substrate 11 is not limited to the sapphire substrate, and may include various other transparent insulating materials. The substrate 11 may include glass, quartz, silicon, an organic polymer, or an organic-inorganic composite material, and may be, for example, silicon carbide (SiC), gallium nitride (GaN), indium gallium nitride (InGaN), aluminum gallium nitride (AlGaN), aluminum nitride (AlN), gallium oxide (Ga2O3), or a silicon substrate. The substrate 11 may further have a roughened surface 11r.

An area of the substrate 11 may define an area of the light emitting device 200. In an embodiment, the area of the substrate 11 may be formed to be same as or greater than a maximum area of the third LED stack 40. The area of the substrate 11 may be about 60,000µm² or less, and further, 30,000 µm² or less, furthermore 10,000µm² or less. The substrate 11 may have a thickness of 30µm to 180µm, specifically, 30µm to 100µm. In an embodiment, the substrate 11 may have an area of 225µm × 225µm and a thickness of 50µm. As a ratio of thickness to area of the substrate 11 decreases, for a total light amount extracted to the outside from the light emitting device 200, it is possible to reduce a ratio of a light amount extracted in a direction parallel to a rear surface of the substrate 11, that is, a side surface, and it is possible to increase a ratio of a light amount transmitted in a direction perpendicular to the rear surface of the substrate 11 and extracted. In particular, by reducing the thickness of the substrate 11, light emitted from the third LED stack 40 adjacent to the substrate 11 may be better emitted in the direction perpendicular to the rear surface of the substrate 11. Accordingly, a color difference according to a viewing angle may be alleviated by reducing a deviation of light extracted from the light emitting device 200. Furthermore, the roughened surface 11r formed on the substrate 11 further increases an extraction efficiency of light emitted in the direction perpendicular to the rear surface of the substrate 11. However, the inventive concepts are not necessarily limited thereto, and the substrate 11 may be removed after the first, second, and third LED stacks 20, 30, and 40 are bonded.

The first, second, and third LED stacks 20, 30, and 40 may emit light having different peak wavelengths from one another. Specifically, light emitted from the first LED stack 20 may pass through the second and third LED stacks 30 and 40. In an embodiment, light loss may be reduced by emitting light of a wavelength longer than that of a LED stack far from the substrate 11, compared to a LED stack close to the substrate 11. For example, the first LED stack 20 may emit light of a wavelength longer than those of the second and third LED stacks 30 and 40, and the second LED stack 30 may emit light of a wavelength longer than that of the third LED stack 40. For example, the first LED stack 20 may emit red light, the second LED stack 30 may emit green light, and the third LED stack 40 may emit blue light.

In another embodiment, to adjust a color mixing ratio of the first, second, and third LED stacks 20, 30, and 40, the second LED stack 30 may emit light of a wavelength shorter than that of the third LED stack 40. Accordingly, a luminous intensity of the second LED stack 30 may be reduced, a luminous intensity of the third LED stack 40 may be increased, and a luminous intensity ratio of light emitted from the first, second, and third LED stacks 20, 30, and 40 may be controlled. For example, the light emitting device may be configured such that the first LED stack 20 emits red light, the second LED stack 30 emits blue light, and the third LED stack 40 emits green light. Accordingly, a luminous intensity of blue light may be relatively reduced, and a luminous intensity of green light may be relatively increased, and thus, a luminous intensity ratio of red, green, and blue may be adjusted to approach 3:6:1. In addition, light emitting areas of the first, second, and third LED stacks 20, 30, and 40 may be 10,000µm² or less, specifically 4,000µm² or less, more specifically 2,500µm² or less. In addition, a light emitting area of a LED stack may be larger as the LED stack is closer to the substrate 11, and the luminous intensity of green light may be further increased by arranging the third LED stack 40 emitting green light closest to the substrate 11. Although the light emitting device 200 is illustrated as including three LED stacks 20, 30 and 40, but the inventive concepts are not limited to a specific number of LED stacks. For example, in some embodiments, the LED stacks may be two, or four or more. Herein, the light emitting device 200 including three LED stacks 20, 30, and 40 according to an embodiment will be exemplarily described.

In the following description, the second LED stack 30 emitting light of a wavelength shorter than that of the third LED stack 40, for example, blue light, will be exemplarily described, but it should be noted that the second LED stack 30 may emit light of a wavelength longer than that of the third LED stack 40, for example, green light.

The first LED stack 20 may include a first conductivity type semiconductor layer 21, an active layer 23, and a second conductivity type semiconductor layer 25. According to an embodiment, the first LED stack 20 may include, for example, a semiconductor material emitting red light, such as AlGaAs, GaAsP, AlGaInP, and GaP, without being limited thereto.

The first upper contact electrode 25p is in ohmic contact with the second conductivity type semiconductor layer 25. The first upper contact electrode 25p may be formed of, for example, a transparent conductive oxide such as indium tin oxide (ITO), without being limited thereto, and for example, it may be formed of a metallic layer capable of being in ohmic contact with the second conductivity type semiconductor layer 25. The first upper contact electrode 25p may be formed of, for example, ITO with a thickness of 200nm to 400nm.

The ohmic contact layer 21n may be disposed on the first conductivity type semiconductor layer 21, and may be in ohmic contact with the first conductivity type semiconductor layer 21. The first upper contact electrode 25p, the active layer 23, and the second conductivity type semiconductor layer 25 may be patterned, and thus, an upper surface of the first conductivity type semiconductor layer 21 may be exposed. The ohmic contact layer 21n may be formed on the exposed first conductivity type semiconductor layer 21.

The ohmic contact layer 21n may have a single-layer structure or a multi-layer structure, and may include Al, Ti, Cr, Ni, Au, Ag, Sn, W, Cu, or an alloy thereof, such as Au-Te alloy or an Au-Ge alloy, without being limited thereto.

In this embodiment, the first conductivity type semiconductor layer 21 may be disposed closer to the substrate 11 than the second conductivity type semiconductor layer 25. Light generated in the active layer 23 may be emitted toward the substrate 11 through the first conductivity type semiconductor layer 21. Light generated in the first LED stack 20 is emitted to the outside through the second LED stack 30 and the third LED stack 40. The first conductivity type semiconductor layer 21 may have a flat shape. However, the inventive concepts are not necessarily limited thereto, the first conductivity type semiconductor layer 21 may further include a roughened surface 21r, and an extraction efficiency of light generated in the active layer 23 may be increased by the roughened surface 21r. A depth D of a concave portion of the roughened surface 21r may be in a range of about 0.1µm to 0.9µm. The roughened surface 21r may be disposed toward the substrate 11, and may contact the first adhesive layer 61. The roughened surface 21r may be formed through wet or dry etching, and a side inclination angle of a protruding portion or the concave portion may be within a range of 35 degrees to 65 degrees. The roughened surface 21r may be a micro-optic surface. Accordingly, when light generated in the first LED stack 20 is directed to the second LED stack 30, it may be focused upward by the micro-optic surface. The micro-optic surface may have an irregular shape, or may have a regular shape. The first adhesive layer 61 may be filled in a depth region of the micro-optic surface. The first adhesive layer 61 may have a refractive index different from that of the micro-optic surface. Therefore, the light extraction efficiency may be improved by increasing a surface area where the micro-optic surface is in contact with a material having a different refractive index. In addition, as the first adhesive layer 61 fills the depth region of the micro-optic surface, areas of different heights are created in the first adhesive layer 61 as well. Accordingly, since the first adhesive layer 61 also serves as the micro-optic, it may be effective in light extraction. Materials of an upper surface and a lower surface of the micro-optic surface may be different from each other, and may have different refractive indices from each other. That is, the micro-optic surface may be disposed to be buried by the materials disposed on upper and lower portions.

In cross section view, a region where the micro-optic surface is formed may be greater than that of the first upper contact electrode 25p. In this case, the region where the micro-optic surface is formed includes a plurality of concavo-convex portions. In addition, the region where the micro-optic surface is formed may be smaller than an area of the second LED stack 30. Accordingly, light emitted through the micro-optic surface may be incident toward the second LED stack 30 as much as possible.

In addition, although it will be described later, a lower insulation layer 81 may include a distributed Bragg reflector (DBR), and by using the lower insulation layer 81 to reflect light generated in the active layer 23, a luminance of light emission of the first LED stack 20 may be increased. The DBR of the lower insulation layer 81 may be formed to have a high reflectance of about 80% or more for light in the wavelength range of 600nm to 650nm.

The second LED stack 30 may include a first conductivity type semiconductor layer 31, an active layer 33, and a second conductivity type semiconductor layer 35. In an embodiment, the second LED stack 30 may include a semiconductor material emitting blue light, such as GaN, InGaN, ZnSe, or the like, without being limited thereto. The second lower contact electrode 35p may be disposed on one surface of the second conductivity type semiconductor layer 35 of the second LED stack 30, and may be in ohmic contact with the second conductivity type semiconductor layer 35. The second lower contact electrode 35p may be formed of a material transparent to light generated in the first LED stack 20 and the third LED stack 30, for example, red light and blue light, and may be formed of, for example, a transparent conductive oxide such as ITO or ZnO. The second lower contact electrode 35p may be formed of, for example, ITO with a thickness of 200nm to 400nm.

In this embodiment, the first conductivity type semiconductor layer 31 of the second LED stack 30 may be disposed to face the first conductivity type semiconductor layer 21 of the first LED stack 20. Accordingly, an upper surface of the first conductivity type semiconductor layer 31 may be exposed regardless of the active layer 33 and the second conductivity type semiconductor layer 35.

The third LED stack 40 may include a first conductivity type semiconductor layer 41, an active layer 43, and a second conductivity type semiconductor layer 45. In an embodiment, the third LED stack 40 may include a semiconductor material emitting green light, such as GaN, InGaN, GaP, AlGaInP, AlGaP, or the like. The third upper contact electrode 45p may be disposed on the second conductivity type semiconductor layer 45 of the third LED stack 40, and may be in ohmic contact with the second conductivity type semiconductor layer 45. The third upper contact electrode 45p may be formed of a material transparent to light generated in the first LED stack 20 and the third LED stack 30, for example, red light and blue light, and may be formed of, for example, a transparent conductive oxide such as ITO or ZnO. The third upper contact electrode 45p may be formed of, for example, ITO with a thickness of 200nm to 400nm.

In this embodiment, the second conductivity type semiconductor layer 45 of the third LED stack 40 faces the second conductivity type semiconductor layer 35 of the second LED stack 30. That is, the second LED stack 30 and the third LED stack 40 are disposed such that the second conductivity type semiconductor layers 35 and 45 having a same polarity face each other. In the second LED stack 30 and the first LED stack 20, the first conductivity type semiconductor layers 21 and 31 having the same polarity are also disposed to face each other. However, the inventive concepts are not necessarily limited thereto, and conductivity type semiconductor layers of different polarities of the second LED stack 30 and the first LED stack 20 may be arranged to face each other.

According to embodiments of the present disclosure, each of the first conductivity type semiconductor layers 21, 31, and 41 and the second conductivity type semiconductor layers 25, 35, and 45 of the first, second, and third LED stacks 20, 30, and 40 may have a single-layer structure or a multi-layer structure, and in some embodiments, may include a superlattice layer. In addition, the active layers 23, 33, and 43 of the first, second, and third LED stacks 20, 30, and 40 may have a single quantum well structure or a multiple quantum well structure.

A total thickness from the first LED stack 20 to the third LED stack 40 may be, for example, about 10µm to about 30µm, specifically, may be about 15µm to about 25µm, and further, may be about 18µm to about 22µm, but the inventive concepts are not limited thereto. In general, the substrate 11 may be thicker than a total thickness of a stacked structure of the first, second, and third LED stacks 20, 30, and 40. In an embodiment, a ratio of the thickness of the substrate 11 to the thickness of the stacked structure of the first, second, and third LED stacks 20, 30, and 40 may be in a range of 1.5:1 to 6:1, further, 1.5:1 to 4:1, and furthermore, 2.27:1 to 2.78: 1. As the thickness ratio decreases, that is, as the thickness of the substrate 11 relative to the thickness of the first, second, and third LED stacks 20, 30, and 40 decreases, for a light amount emitted to the outside of the light emitting device 200, a ratio of a light amount extracted to the side surface of the substrate 11 decreases, and a ratio of a light amount extracted in the direction perpendicular to the rear surface of the substrate 11 through the substrate 11 increases. Accordingly, a color difference according to a viewing angle may be alleviated by reducing a difference in radiation patterns of light extracted from the light emitting device 200.

Each of the first upper contact electrode 25p, the second lower contact electrode 35p, and the third upper contact electrode 45p may include a transparent conductive material that transmits light. For example, the contact electrodes 25p, 35p, and 45p may be a transparent conductive oxide (TCO), and the transparent conductive oxide (TCO) may include SnO, InO2, ZnO, ITO, ITZO, or the like, but the inventive concepts are not limited thereto.

The first adhesive layer 61 may be disposed between the first LED stack 20 and the second LED stack 30, and the second adhesive layer 63 may be disposed between the second LED stack 30 and the third LED stack 40. In an embodiment, the first adhesive layer 61 may contact the first conductivity type semiconductor layer 21 of the first LED stack 20 and the first conductivity type semiconductor layer 31 of the second LED stack 30.

The first adhesive layer 61 may include regions having different thicknesses from each other, that is, a thick region and a thin region. A thickness of the second adhesive layer 63 may be smaller than a maximum thickness of the thick region of the first adhesive layer 61 and greater than a minimum thickness of the thin region of the first adhesive layer 61. The second adhesive layer 63 may be formed to have a thickness within a range of 1.8µm to 2.2µm, for example. The first and second adhesive layers 61 and 63 may include a non-conductive material that transmits light. For example, the first and second adhesive layers 61 and 63 may include an optically clear adhesive (OCA), and may include, for example, epoxy, silicone, polyimide, SU8, spin-on- Glass (SOG) and benzocyclobutene (BCB), but the inventive concepts are not limited thereto. The first adhesive layer 61 and the second adhesive layer 63 do not have to be identical to each other, and may be formed of different materials from each other, for example, materials having different refractive indices, melting points, or transmittances.

As shown in a partial enlarged area of FIG. 12B, a first stress relief layer 51 may be disposed on an upper surface of the second adhesive layer 63, and may be positioned between the second adhesive layer 63 and the second LED stack 30. A second stress relief layer 53 may be disposed on a lower surface of the second adhesive layer 63, and positioned between the second adhesive layer 63 and the third LED stack 40. Each of the first and second stress relief layers 51 and 53 may be formed to have a thickness of, for example, 50nm to 150nm. The first and second stress relief layers 51 and 53 may include an insulating material. For example, the first and second stress relief layers 51 and 53 may include organic or inorganic insulating materials such as polyimide, SiO₂, SiNx, Al₂O₃, and the like, and for example, may be SiO₂, but the inventive concepts are not limited thereto.

The first and second stress relief layers 51 and 53 may be disposed between the LED stacks when the first, second, and third LED stacks 20, 30, and 40 are arranged to vertically overlap one another. More specifically, in a process of sequentially bonding the second LED stack 30 and the first LED stack 20 on the third LED stack 40, warpage of the substrate 11 may occur, and as a result, cracks may occur between the LED stacks 20, 30, and 40. The first and second stress relief layers 51 and 53 disposed between the LED stacks 20, 30, and 40 may relieve the warpage of the substrate 11, and thus, defects such as cracks that may occur between the LED stacks 20, 30, and 40 may be prevented. The stress relief layers may also be disposed in an upper portion and a lower portion of the first adhesive layer 61.

The lower insulation layer 81 may cover upper surfaces and side surfaces of the first, second, and third LED stacks 20, 30, and 40. The lower insulation layer 81 may include various organic or inorganic insulating materials, such as polyimide, SiO₂, SiNx, Al₂O₃, or the like. The lower insulation layer 81 may have a single-layer structure or a multi-layer structure, and an example of the multi-layer structure may include a distributed Bragg reflector (DBR). In an embodiment, the lower insulation layer 81 may include a distributed Bragg reflector including a first material layer having a first refractive index and a second material layer having a second refractive index. The first material layer may have a lower refractive index, and the second material layer may have a higher refractive index. The "lower refractive index" and the "higher refractive index" refer to a relative difference in refractive indices comparing those of the first material layer and the second material layer. In an embodiment, the first material layers may be SiO₂, and the second material layers may be TiO₂. The refractive index of SiO₂ of the first material layer is about 1.47, and the refractive index of TiO₂ is about 2.41. However, in the present disclosure, the first material layer and the second material layer are not limited to SiO₂ and TiO₂, and for example, the first and second material layers may be formed of Si₃N₄, MgF₂, Nb₂O₅, ZnS, ZrO2, ZnO or a compound semiconductor or the like. However, the difference in refractive indices between the first material layer and the second material layer may be greater than 0.5.

The distributed Bragg reflector DBR may be formed by repeatedly stacking pairs of the first material layer and the second material layer a plurality of times. In general, material layers having a higher refractive index have a higher absorption rate than material layers having a lower refractive index. Therefore, controlling optical thicknesses of the second material layers having a higher refractive index to be smaller than optical thicknesses of the first material layers having a lower refractive index may reduce loss due to light absorption. Accordingly, each thickness of SiO₂ which is the first material layer may be formed to be thicker than each thickness of TiO₂ which is the second material layer.

The first material layers forming the distributed Bragg reflector (DBR) may be formed such that at least two layers have different thicknesses. Alternatively, the second material layers forming the distributed Bragg reflector (DBR) may be formed such that at least two layers have different thicknesses. Since the distributed Bragg reflector (DBR) have to function optically for different peak wavelengths generated in each of the LED stacks 20, 30, and 40, the first material layer or the second material layer may improve optical functions such as light reflection or light path change for a plurality of peak wavelength by forming at least two layers with different thicknesses.

In addition, a first layer and a last layer of the distributed Bragg reflector (DBR) may be SiO₂. By using the SiO₂ as the first layer of the distributed Bragg reflector (DBR), an adhesion between the semiconductor layers and the first upper contact electrode 25p may be enhanced, and by using SiO₂ which is the last layer, the distributed Bragg reflector (DBR) may be protected, and adhesions of the upper insulation layer 183 and the electrode pads 20pd, 30pd, 40pd, and 50pd which will be described later may be enhanced.

According to an embodiment, the distributed Bragg reflector (DBR) may have a reflectance of 80% or more, further, 90% or more, and furthermore, 95% or more over the wavelength range of 600nm to 650nm, and thus, light emitted and incident from the light emitting device 200, in particular, from the first LED stack 20, may be reflected with a high reflectance. The distributed Bragg reflector (DBR) may include, for example, 16 to 25 pairs of the first material layer and the second material layer, without being limited thereto. The distributed Bragg reflector may have a thickness of about 1.5µm to about 3µm. The distributed Bragg reflector (DBR) may exhibit a reflectance of 90% or more over a wavelength range of 410nm to 700nm.

In this embodiment, the first upper contact electrode 25p and the ohmic contact layer 21n may be disposed between the first through third LED stacks 20, 30, and 40 and the lower insulation layer 81, and at least partial regions of the upper contact electrode 25p and the ohmic contact layer 21n may be covered by the lower insulation layer 81. The lower insulation layer 81 contacts the first conductivity type semiconductor layers 21, 31, and 41 of the first through third LED stacks 20, 30, and 40. The distributed Bragg reflector (DBR) may be formed to have a reflectance higher than those of metal layers in a specific wavelength band. Accordingly, even when no other light reflective conductive layer is disposed between the distributed Bragg reflector and the first through third LED stacks 20, 30, and 40, light may be reflected in a wide region. Accordingly, the light emitting device 200 according to this embodiment may further increase the luminance of light emitted from the first through third LED stacks 20, 30, and 40.

The lower insulation layer 81 may be formed to extend over the first conductivity type semiconductor layer 41 of the third LED stack 40. In addition, the lower insulation layer 81 may cover a side surface of the first conductivity type semiconductor layer 41 of the third LED stack 40. An outer edge of the lower insulation layer 81 may be disposed in a region between the side surface of the first conductivity type semiconductor layer 41 and the side surface of the substrate 11. In an embodiment, the edge of the lower insulation layer 81 may overlap with an edge of the substrate 11.

The lower insulation layer 81 has openings 20CH, 30CH, 40CH, 50CHa, 50CHb, and 50CHc to allow electrical connection to the first through third LED stacks 20, 30, and 40. The openings may include a first contact hole 20CH to allow electrical connection to the second conductivity type semiconductor layer 25 of the first LED stack 20, a second contact hole 30CH to allow electrical connection to the second conductivity type semiconductor layer 35 of the second LED stack 30, a third contact hole 40CH to allow electrical connection to the second conductivity type semiconductor layer 45 of the third LED stack 40, and first through third sub-contact holes 50CHa, 50CHb, and 50CHc to allow electrical connection to the first conductivity type semiconductor layers 21, 31, and 41 of the first through third LED stacks 20, 30, and 40. For example, the first contact hole 20CH may expose the first upper contact electrode 25p, the second contact hole 30CH may expose the second lower contact electrode 35p, and the third contact hole 40CH may expose the third upper contact electrode 45p. In addition, the first through third sub-contact holes 50CHa, 50CHb, and 50CHc may expose the first conductivity type semiconductor layers 21, 31, and 41 of the first through third LED stacks 20, 30, and 40, respectively. When additional ohmic electrodes are disposed on the first conductivity type semiconductor layers 21, 31, and 41 of the first through third LED stacks 20, 30, and 40, the ohmic electrode may be exposed by the first through third sub-contact holes 50CHa, 50CHb, and 50CHc.

The lower insulation layer 81 may cover the side surface of the first conductivity type semiconductor layer 41 and extend to an upper surface of the substrate 11, and an end terminal of the lower insulation layer 81 may be covered by the upper insulation layer 183, which will be described later. However, the inventive concepts are not necessarily limited thereto, and the end terminal of the lower insulation layer 81 may be disposed in flush with the side surface of the substrate 11, and thus, the end terminal of the lower insulation layer 81 may be exposed to the outside between the substrate 11 and the upper insulation layer 183.

In an embodiment, the first through third sub-contact holes 50CHa, 50CHb, and 50CHc may be arranged on a diagonal line. In an embodiment, the first contact hole 20CH and the second contact hole 30CH may be arranged on one diagonal line, and at least partial regions of the first contact hole 20CH and the second contact hole 30CH may overlap with the one diagonal line. That is, one diagonal line may pass through the first contact hole 20CH and the second contact hole 30CH. The third contact hole 40CH and the first through third sub-contact holes 50CHa, 50CHb, and 50CHc may be arranged on a different diagonal line, and at least partial regions of the third contact hole 40CH and the first through third sub-contact holes 50CHa, 50CHb, and 50CHc may overlap with the different diagonal line. That is, the different diagonal line may pass through the third contact hole 40CH and the first through third sub-contact holes 50CHa, 50CHb, and 50CHc, or may pass through only the first through third sub-contact holes 50CHa, 50CHb, and 50CHc. However, the inventive concepts are not limited thereto, and the first through third contact holes 20CH, 30CH, and 40CH and the first through third sub-contact holes 50CHa, 50CHb, and 50CHc may be arranged in various locations.

The upper insulation layer 183 is disposed on the lower insulation layer 81. The upper insulation layer 183 may be formed on the lower insulation layer 81 to contact the lower insulation layer 81. The upper insulation layer 183 may include epoxy molding compound (EMC), polyimide (PI), or the like. The upper insulation layer 183 may also include a photosensitive material. The upper insulation layer 183 may be applied on the lower insulation layer 81 using spin coating, and patterned using exposure and development techniques. The upper insulation layer 183 may also be provided as a dry film rather than a liquid type to increase flatness.

The upper insulation layer 183 may be formed to at least partially expose each of the openings 20CH, 30CH, 40CH, 50CHa, 50CHb, and 50CHc of the lower insulation layer 81 to allow electrical connection. For example, the upper insulation layer 183 may include openings 20ct, 30ct, 40ct, 50cta, 50ctb, and 50ctc, and as shown in FIG. 12A, the openings 20ct, 30ct, 40ct, 50cta, 50ctb, and 50ctc may be disposed corresponding to the openings 20CH, 30CH, 40CH, 50CHa, 50CHb, and 50CHc of the lower insulation layer 81. For example, a first opening 20ct may at least partially overlap with the first contact hole 20CH, a second opening 30ct may at least partially overlap with the second contact hole 30CH, and a third opening 40ct may at least partially overlap with the third contact hole 40CH. In addition, first through third sub-openings 50cta, 50ctb, and 50ctc may at least partially overlap with the first through third sub-contact holes 50CHa, 50CHb, and 50CHc, respectively. In a modified embodiment, instead of the first through third sub-openings 50cta, 50ctb, and 50ctc, one opening may be formed across the first through third sub-contact holes 50CHa, 50CHb, and 50CHc. Sizes of the openings 20ct, 30ct, 40ct, 50cta, 50ctb, and 50ctc of the upper insulation layer 183 may be different from those of corresponding openings 20CH, 30CH, 40CH, 50CHa, 50CHb, and 50CHc of the lower insulation layer 81. Accordingly, reflection efficiency may be increased by forming a step to increase a surface area on which an electrode is formed. However, the inventive concepts are not necessarily limited thereto, and side surfaces of the openings 20ct, 30ct, 40ct, 50cta, 50ctb, and 50ctc of the upper insulation layer 183 may be formed in flush with side surfaces of the corresponding openings 20CH, 30CH, 40CH, 50CHa, 50CHb, and 50CHc of the lower insulation layer 81 not to have a step, and thus, the electrode may be formed stably.

Each of the first, second, and third LED stacks 20, 30, and 40 may be driven independently. In an embodiment, a common voltage may be applied to the first conductivity type semiconductor layers 21, 31, and 41 of the first, second, and third LED stacks 20, 30, and 40, and an individual signal may be applied to each of the second conductivity type semiconductor layers 25, 35, and 45. In another embodiment, an individual signal may be applied to each of the first conductivity type semiconductor layers 21, 31, and 41 of the first, second, and third LED stacks 20, 30, and 40, and a common voltage may be applied to the second conductivity type semiconductor layers 25, 35, and 45. For example, the first conductivity type semiconductor layers 21, 31, and 41 of each of the LED stacks 20, 30, and 40 may be an n-type, and the second conductivity type semiconductor layers 25, 35, and 45 may be a p-type. In this case, a common voltage may be applied to the first conductivity type semiconductor layers 21, 31, and 41, and an individual signal may be applied to each of the second conductivity type semiconductor layers 25, 35, and 45, or vice versa. When the first, second, and third LED stacks 20, 30, and 40 are vertically stacked, the second LED stack 30 may have an opposite stacking sequence compared to those of the first and third LED stacks 20 and 40. That is, the second conductivity type semiconductor layer 35 of the second LED stack 30, for example, a p-type semiconductor layer 35 may be disposed under the active layer 33, and the second conductivity type semiconductor layer 45 of the third LED stack 40 may be disposed over the active layer 33. A manufacturing process of the light emitting device 200 may be simplified by making the stacking sequence of the second LED stack 30 opposite to the stacking sequence of the third LED stack 40. In this embodiment, it has been described that the first conductivity type semiconductor layer and the second conductivity type semiconductor layer are the n-type and the p-type, respectively, but inventive concepts are not limited thereto, or vice versa.

According to the illustrated embodiment, the light emitting device 200 may include a first electrode pad layer 20pd, a second electrode pad layer 30pd, a third electrode pad layer40pd, and a fourth electrode pad layer 50pd. The second conductivity type semiconductor layers 25, 35, and 45 of the LED stacks 20, 30, and 40 may be respectively connected to the first electrode pad layer 20pd, the second electrode pad layer 30pd, and the third electrode pad layer 40pd to receive a corresponding signal, respectively. Meanwhile, the first conductivity type semiconductor layers 21, 31, and 41 of the first through third LED stacks 20, 30, and 40 may be connected to the fourth electrode pad layer 50pd to receive a common signal or voltage from the outside. In this way, each of the first, second, and third LED stacks 20, 30, and 40 may be driven independently while having a common n-type electrode to which a common signal or voltage is applied, but the inventive concepts are not limited thereto.

The first through fourth electrode pad layers 20pd, 30pd, 40pd, and 50pd are disposed on the upper insulation layer 183. The first electrode pad layer 20pd may be connected to the first upper contact electrode 25p through the first opening 20ct of the upper insulation layer 183 and the first contact hole 20CH of the lower insulation layer 81, and may be electrically connected to the second conductivity type semiconductor layer 25. The first electrode pad layer 20pd may extend from an upper surface of the upper insulation layer 183 to pass through the first opening 20ct of the upper insulation layer 183 and the first contact hole 20CH of the lower insulation layer 81. The upper surface of the upper insulation layer 183 that contacts a lower portion of the first electrode pad layer 20pd may include a curved surface, which may prevent surface cracks that may occur on the surface of the upper insulation layer 183. In cross section view, lengths on both sides of the first electrode pad layer 20pd may be different from each other based on a center of the first opening 20ct of the upper insulation layer 183. Preferably, a length of the first electrode pad layer 20pd extends from the center of the first opening 20ct toward the outside of the light emitting device may be greater than a length of the first electrode pad layer 20pd extends from the center of the first opening 20ct toward a center of the light emitting device. Accordingly, a stable electrical connection with an external circuit is possible.

The second electrode pad layer 30pd may be connected to the second lower contact electrode 35p through the second opening 30ct of the upper insulation layer 183 and the second contact hole 30CH of the lower insulation layer 81, and may be electrically connected to the second conductivity type semiconductor layer 35. The second electrode pad layer 30pd may extend from the upper surface of the upper insulation layer 183 to pass through the second opening 30ct of the upper insulation layer 183 and the second contact hole 30CH of the lower insulation layer 81. The upper surface of the upper insulation layer 183 that contacts a lower portion of the second electrode pad layer 30pd may include a curved surface, which may prevent surface cracks that may occur on the surface of the upper insulation layer 183. In cross section view, lengths on both sides of the second electrode pad layer 30pd may be different from each other based on a center of the second opening 30ct of the upper insulation layer 183. Preferably, a length of the second electrode pad layer 30pd extends from the center of the second opening 30ct toward the outside of the light emitting device may be greater than a length of the second electrode pad layer 30pd extends from the center of the second opening 30ct toward the center of the light emitting device. Therefore, a stable electrical connection with an external circuit is possible.

The third electrode pad layer 40pd may be connected to the third upper contact electrode 45p through the third opening 40ct of the upper insulation layer 183 and the third contact hole 40CH of the lower insulation layer 81, and may be electrically connected to the second conductivity type semiconductor layer 45. The third electrode pad layer 40pd may extend from the upper surface of the upper insulation layer 183 to pass through the third opening 30ct of the upper insulation layer 183 and the third contact hole 40CH of the lower insulation layer 81. The upper surface of the upper insulation layer 183 that contacts a lower portion of the third electrode pad layer 40pd may include a curved surface, which may prevent surface cracks that may occur on the surface of the upper insulation layer 183. In cross section view, lengths on both sides of the third electrode pad layer 40pd may be different from each other based on a center of the third opening 40ct of the upper insulation layer 183. Preferably, a length of the third electrode pad layer 40pd extends from the center of the third opening 40ct toward the outside of the light emitting device may be greater than a length of the third electrode pad layer 40pd extends from the center of the third opening 40ct toward the center of the light emitting device. Accordingly, a stable electrical connection with an external circuit is possible.

The first through third electrode pad layers 20pd, 30pd, and 40pd may extend from the upper surface of the upper insulation layer 183, respectively, through the first through third contact holes 20CH, 30CH, and 40CH of the lower insulation layer 81 to directly contact the first upper contact electrode 25p, the second lower contact electrode 35p, and the third upper contact electrode 45p.

The fourth electrode pad layer 50pd is commonly electrically connected to the first conductivity type semiconductor layers 21, 31, and 41 of the first, second, and third LED stacks 20, 30, and 40. For example, the fourth electrode pad layer 50pd may be electrically connected to the first conductivity type semiconductor layers 21, 31, and 41 of the first, second, and third LED stacks 20, 30, and 40 through the first sub-opening 50cta, the second sub-opening 50ctb, and the third sub-opening 50ctc of the upper insulation layer 183 and the first sub-contact hole 50CHa, the second sub-contact hole 50CHb, and the third sub-contact hole 50CHc of the lower insulation layer 81. The fourth electrode pad layer 50pd may extend from the upper surface of the upper insulation layer 183 to pass through the first through third sub-openings 50cta, 50ctb, and 50ctc and first through third sub-contact holes 50CHa, 50CHb, and 50CHc, and may directly contact the ohmic contact layer 21n and the first conductivity type semiconductor layers 31 and 41 of the second and third LED stacks 30 and 40.

In cross section view, the fourth electrode pad layer 50pd may include a convex portion P formed convexly along the surface of the upper insulation layer 183 between the first through third sub-openings 50cta, 50ctb, and 50ctc. The convex portion P of the fourth electrode pad layer 50pd is formed in a direction opposite to a light extraction direction. The convex portion P may be formed in plurality, and locations of vertices of the convex portions P may be different from one another. The convex portion P may have different vertical lengths on both sides of the fourth electrode pad layer 50pd with respect to the vertex. In another embodiment, the vertices included in the plurality of convex portions P may be positioned at a same level. Alternatively, the vertical length of the fourth electrode pad layer 50pd disposed close to the outside of the light emitting device may be longer.

The first through fourth electrode pad layers 20pd, 30pd, 40pd, and 50pd may have a same layer structure. For example, the first through fourth electrode pad layers 20pd, 30pd, 40pd, and 50pd may have a multi-layer metal stacked structure, and may include a metallic layer capable of being in ohmic contact with the first conductivity type semiconductor layers 31 and 41 of the second and third LED stacks 30 and 40. For example, the first through fourth electrode pad layers 20pd, 30pd, 40pd, and 50pd may include Ni/Al for ohmic contact. Furthermore, the first through fourth electrode pad layers 20pd, 30pd, 40pd, and 50pd may include an Au layer as an uppermost layer, and may include a plurality of Ti/Ni layers.

Meanwhile, as shown in FIG. 12A, the first through fourth electrode pad layers 20pd, 30pd, 40pd, and 50pd may be arranged in a diagonal direction of the light emitting device 200. The first through fourth electrode pad layers 20pd, 30pd, 40pd, and 50pd may be disposed close to corners of the light emitting device 200, respectively. As shown in FIG. 12A, each of the first through third electrode pad layers 20pd, 30pd, and 40pd may extend more lengthily to the outside of the light emitting device 200 than a length extending toward the center of the light emitting device 200 from the contact holes 20CH, 30CH, and 40CH. The first, second, third, and fourth electrode pad layers 20pd, 30pd, 40pd, and 50pd are spaced apart from one another. According to an embodiment of the present disclosure, each of the first, second, third, and fourth electrode pad layers 20pd, 30pd, 40pd, and 50pd may cover portions of the side surfaces of the first, second, and third LED stacks 20, 30, and 40.

Meanwhile, as shown in FIG. 12B, the fourth electrode pad layer 50pd may include a curved upper surface. The first through third electrode pad layers 20pd, 30pd, and 40pd may also include a curved upper surface. However, the inventive concepts are not limited thereto, and the upper surfaces of the first through fourth electrode pad layers 20pd, 30pd, 40pd, and 50pd may be flat.

In this embodiment, the first through fourth electrode pad layers 20pd, 30pd, 40pd, and 50pd are layers that are bonded by a bonding layer when the light emitting device 200 is mounted on a circuit board. These first through fourth electrode pad layers 20pd, 30pd, 40pd, and 50pd pass through the openings of the upper insulation layer 183 and the lower insulation layer 81. Accordingly, there is no need to dispose a separate conductive layer between the upper insulating layer 183 and the lower insulating layer 81, thereby simplifying a structure of the light emitting device 200.

A plurality of light emitting devices 200 may be formed by being arrayed on the substrate 11. The substrate 11 may be cut along a scribing line to be separated into each of the light emitting devices 200, and the light emitting devices 200 may be transferred to another substrate or a tape using various transferring techniques for subsequent processes such as packaging or modularization.

Hereinafter, a method of manufacturing the light emitting device 200 according to an embodiment of the present disclosure will be described. Details described in the above-described embodiment will be briefly described or omitted.

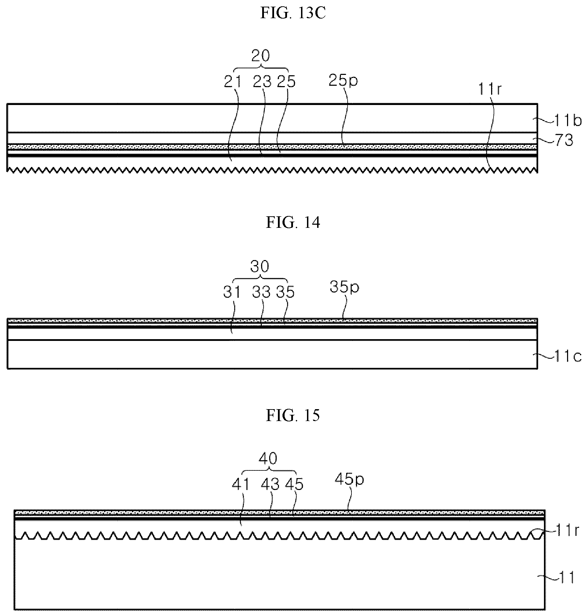

FIGs. 13A, 13B, and 13C are schematic cross-sectional views illustrating steps of providing a first LED stack according to an embodiment of the present disclosure, and FIG. 14 is a schematic cross-sectional view illustrating a step of providing a second LED stack according to an embodiment of the present disclosure, and FIG. 15 is a schematic cross-sectional view illustrating a step of providing a third LED stack according to an embodiment of the present disclosure.

First, referring to FIG. 13A, a first LED stack 20 including a first conductivity type semiconductor layer 21, an active layer 23, and a second conductivity type semiconductor layer 25 is grown on a substrate 11a. The substrate 11a may be, for example, a GaAs substrate. The first LED stack 20 may be grown by, for example, a metal organic chemical vapor deposition (MOCVD) method or a molecular beam epitaxy (MBE) method. A first upper contact electrode 25p may be formed on the second conductivity type semiconductor layer 25. The first upper contact electrode 25p may include a transparent conductive oxide (TCO) such as SnO, InO₂, ZnO, ITO, ITZO, and the like.

Referring to FIG. 13B, a carrier substrate 11b may be attached to the first upper contact electrode 25p using an adhesive 73. The carrier substrate 11b may be, for example, a sapphire substrate, without being limited thereto. After the carrier substrate 11b is attached, the substrate 11a may be removed. The substrate 11a may be removed using, for example, a wet etching technique. As the substrate 11a is removed, a lower surface of the first conductivity type semiconductor layer 21 may be exposed.

Referring to FIG. 13C, a roughened surface 21r may be formed by etching the lower surface of the first conductivity type semiconductor layer 21 using a wet or dry etching technique. As described with reference to FIG. 12B, a depth D of a roughened surface 21r may be in a range of about 0.1µm to about 0.9µm. The roughened surface 21r may be a micro-optic surface. Accordingly, when light generated in the first LED stack 20 is directed to a second LED stack 30, it may be focused upward by the micro-optic surface. The micro-optic surface may have an irregular shape, or may have a regular shape.

Meanwhile, referring to FIG. 14, the second LED stack 30 including a first conductivity type semiconductor layer 31, an active layer 33, and a second conductivity type semiconductor layer 35 is grown on a substrate 11c. The substrate 11c may be, for example, a sapphire substrate, without being limited thereto. The first conductivity type semiconductor layer 31, the active layer 33, and the second conductivity type semiconductor layer 35 may be sequentially grown on the substrate 11c by a metal organic chemical vapor deposition (MOCVD) method or a molecular beam epitaxy (MBE) method.

A second lower contact electrode 35p may be formed on the second conductivity type semiconductor layer 35. The second lower contact electrode 35p may be formed on the second conductivity type semiconductor layer 35 by a physical vapor deposition method or a chemical vapor deposition method. The second lower contact electrode 35p may include a transparent conductive oxide (TCO) such as SnO, InO₂, ZnO, ITO, ITZO, and the like. Furthermore, although not shown in the drawings, a first stress relief layer 51 may be formed on the second lower contact electrode 35p as described with reference to FIG. 12B. The first stress relief layer 51 may be formed of, for example, SiO₂.

Referring to FIG. 15, a third LED stack 40 including a first conductivity type semiconductor layer 41, an active layer 43, and a second conductivity type semiconductor layer 45 may be grown on a substrate 11. The substrate 11 may be a sapphire substrate, without being limited thereto. The substrate 11 may include a roughened surface 11r. The first conductivity type semiconductor layer 41, the active layer 43, and the second conductivity type semiconductor layer 45 may be grown on the substrate 11 by a metal organic chemical vapor deposition (MOCVD) method or a molecular beam epitaxy (MBE) method. A third upper contact electrode 45p may be formed on the second conductivity type semiconductor layer 45. The third upper contact electrode 45p may be formed on the second conductivity type semiconductor layer 45 by a physical vapor deposition method or a chemical vapor deposition method, and may include a transparent conductive oxide (TCO) such as SnO, InO₂, ZnO, ITO, ITZO, and the like. Furthermore, although not shown in the drawings, a second stress relief layer 53 may be formed on the third upper contact electrode 45p as described with reference to FIG. 12B. The second stress relief layer 53 may be formed of, for example, SiO₂. According to an embodiment of the present disclosure, the third LED stack 40 may emit green light.

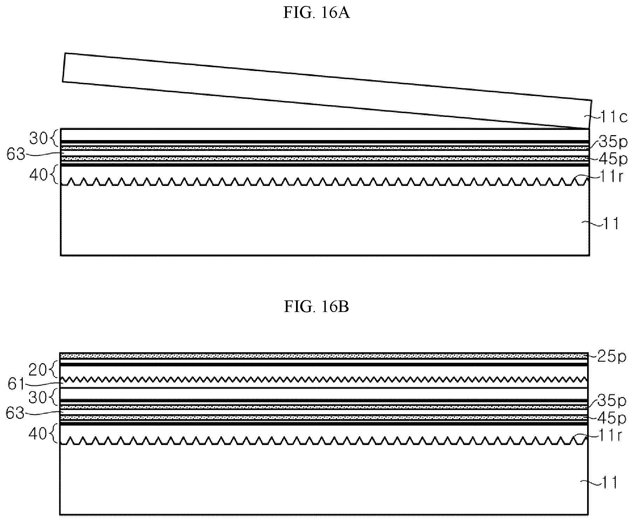

Referring to FIG. 16A, the second and third LED stacks 30 and 40 are coupled to each other with the second adhesive layer 63 interposed therebetween, and the substrate 11c on which the second LED stack 30 is grown may be removed by a laser lift-off process, a chemical process, a mechanical process, and the like. The stress relief layers 51 and 53 may be interposed between the second adhesive layer 63 and the second lower contact electrode 35p and the third upper contact electrode 45p, respectively. Accordingly, the second LED stack 30 and the third LED stack 40 are coupled such that second conductivity type semiconductor layer 35 of the second LED stack 30 faces the second conductivity type semiconductor layer 45 of the third LED stack 40.

Referring to FIG. 16B, the first LED stack 20 of FIG. 13C may be coupled with the second LED stack 30 with the first adhesive layer 61 interposed therebetween, and the substrate 11b to which the first LED stack 20 is attached may be removed from the first LED stack 20 together with the adhesive 73. Accordingly, the first LED stack 20 and the second LED stack 30 are coupled such that the first conductivity type semiconductor layer 21 of the first LED stack 20 faces the first conductivity type semiconductor layer 31 of the second LED stack 30.

While the LED stacks 20, 30, and 40 are bonded to one another, and the substrates 11b and 11c of the first and second LED stacks 20 and 30 are separated, warpage may occur in the substrate 11 due to a difference in thermal expansion coefficient, and as a result, cracks may occur between the LED stacks 20, 30, and 40. However, in this embodiment, by disposing the first and second stress relief layers 51 and 53 between the LED stacks 20, 30, and 40, a defect such as cracks of the LED stacks 20, 30, and 40 may be prevented from occurring.

Subsequently, the light emitting device 200 is manufactured using a coupled structure of the first LED stack 20, the second LED stack 30, and the third LED stack 40, and hereinafter, a method of manufacturing the light emitting device 200 will be described in detail.

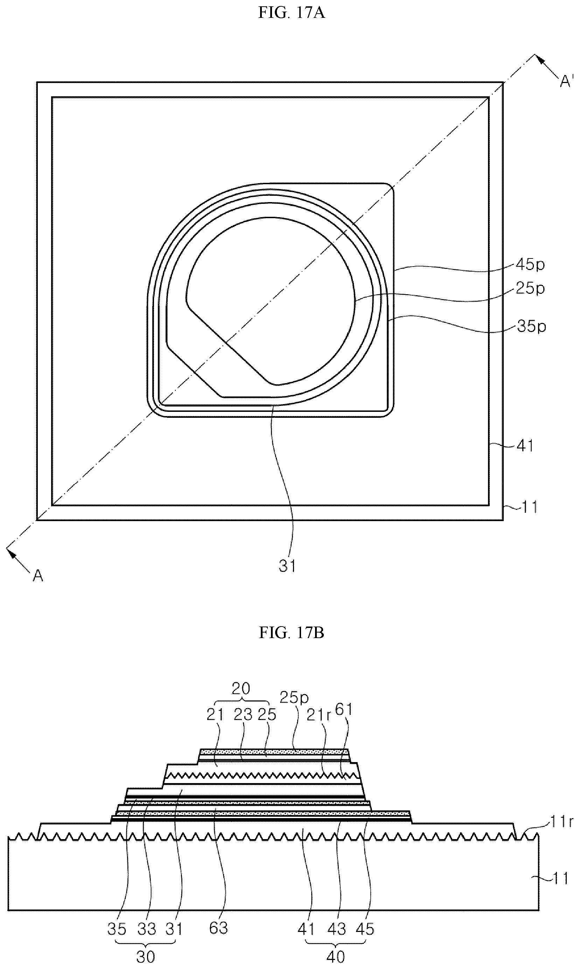

FIGs. 17A, 18A, 19A, 20A, and 21A are schematic plan views illustrating a method of manufacturing the light emitting device 200 according to an embodiment of the present disclosure. FIGs. 17B, 18B, 19B, 20B, and 21B are schematic cross-sectional views taken along line A-A' in FIGs. 17A, 18A, 19A, 20A, and 21A.

Referring to FIGs. 17A and 17B, various portions of the first, second, and third LED stacks 20, 30, and 40, the first upper contact electrode 25p, the second lower contact electrode 35p, and the third upper contact electrode 45p may be patterned through photolithography and etching processes, and together with an upper surface of the first upper contact electrode 25p, at least a portion of each of the first conductivity type semiconductor layer 21 of the first LED stack 20, the first conductivity type semiconductor layer 31 of the second LED stack 30, the second lower contact electrode 35p, the third upper contact electrode 45p, and the first conductivity type semiconductor layer 41 of the third LED stack 40 may be exposed. The first adhesive layer 61 may be patterned together with the first conductivity type semiconductor layer 21, and the first stress relief layer 51, the second adhesive layer 63, and the second stress relief layer 53 may be patterned together with the lower contact electrode 35p. However, the inventive concepts are not limited thereto. For example, the first stress relief layer 51, the second adhesive layer 63, and the second stress relief layer 53 may be patterned through a process separate from a patterning process of the second lower contact electrode 35p.

The first LED stack 20 may have a smallest area among the LED stacks 20, 30, and 40. Meanwhile, the third LED stack 40 may have a largest area among the LED stacks 20, 30, and 40, and thus, a luminous intensity of the third LED stack 40 may be relatively increased. However, the inventive concepts are not limited thereto, and relative sizes of the LED stacks 20, 30, and 40 are not particularly limited.

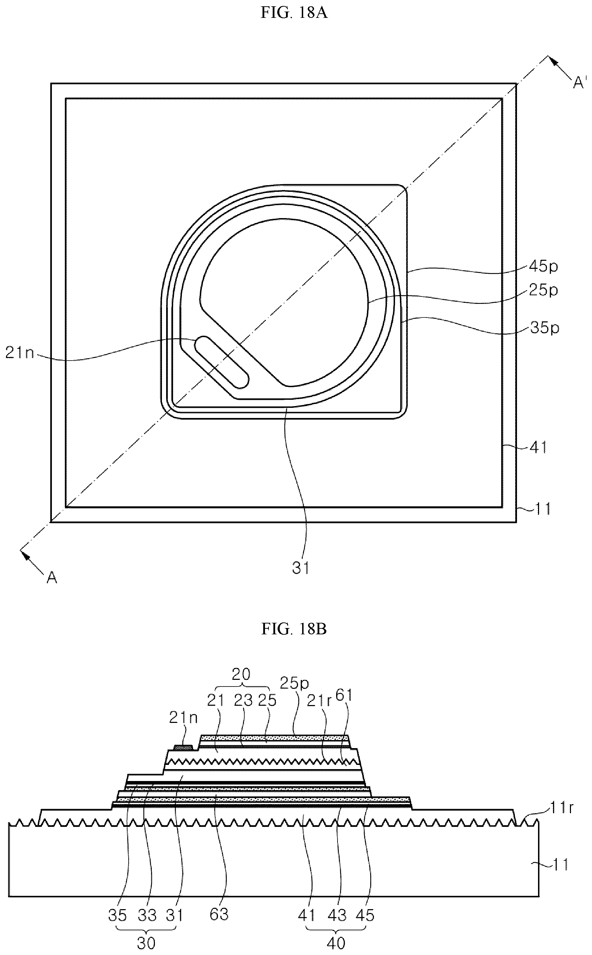

Referring to FIGs. 18A and 18B, an ohmic contact layer 21n may be formed on the first conductivity type semiconductor layer 21 of the first LED stack 20. The ohmic contact layer 21n is formed to have a thickness of, for example, about 100nm in an exposed region of the first conductivity type semiconductor layer 21, which may improve ohmic contact. The ohmic contact layer 21n may be formed of a metallic layer.

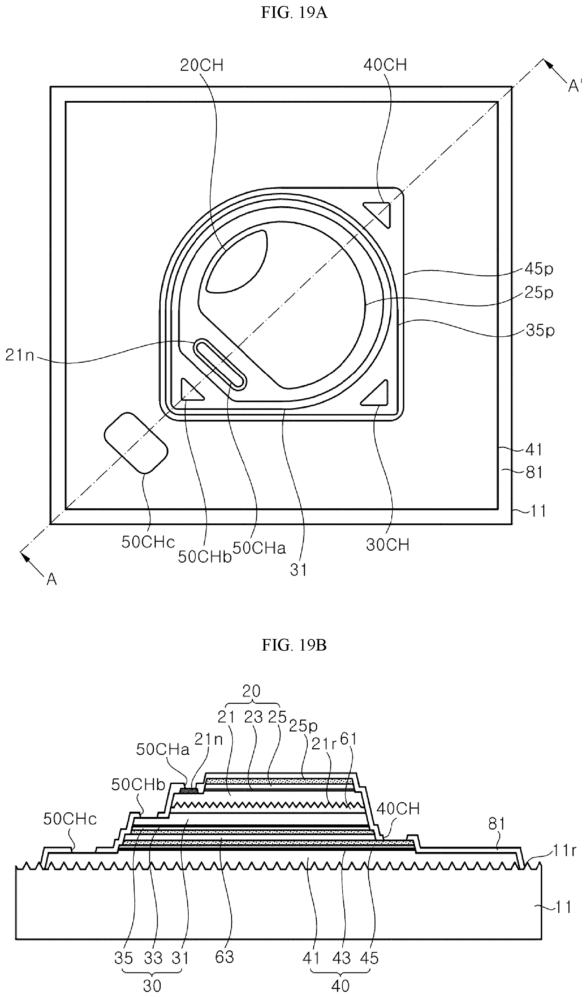

Referring to FIGs. 19A and 19B, after the ohmic contact layer 21n is formed, a lower insulation layer 81 may be formed. The lower insulation layer 81 may be formed, for example, in a single-layer structure or a multi-layer structure. The lower insulation layer 81 may include SiO₂. The lower insulation layer 81 may also include a distributed Bragg reflector (DBR), and for example, SiO₂ and TiO₂ may be alternately stacked to form the distributed Bragg reflector.

The lower insulation layer 81 may be patterned to have openings to allow electrical connection to the first through third LED stacks 20, 30, and 40. For example, the lower insulation layer 81 may have a first, a second, and a third contact holes 20CH, 30CH, and 40CH exposing the first upper contact electrode 25p, the second lower contact electrode 35p, and the third upper contact electrode 45p, respectively, and first through third sub-contact holes 50CHa, 50CHb, and 50CHc exposing the ohmic contact layer 21n, the first conductivity type semiconductor layer 31, and the first conductivity type semiconductor layer 41.

The first contact hole 20CH may be defined on the first upper contact electrode 25p to expose a portion of the first upper contact electrode 25p. The second contact hole 30CH may be defined on the second lower contact electrode 35p to expose a portion of the second lower contact electrode 35p. The third contact hole 40CH may be defined on the third upper contact electrode 45p to expose a portion of the third upper contact electrode 45p. The first through third sub-contact holes 50CHa, 50CHb, and 50CHc may be formed to allow electrical connection to the first conductivity type semiconductor layers 21, 31, and 41 of each of the first, second, and third LED stacks 20, 30, and 40, and may expose the ohmic contact layer 21n, the first conductivity type semiconductor layer 31 of the second LED stack 30, and the first conductivity type semiconductor layer 41 of the third LED stack 40, respectively.

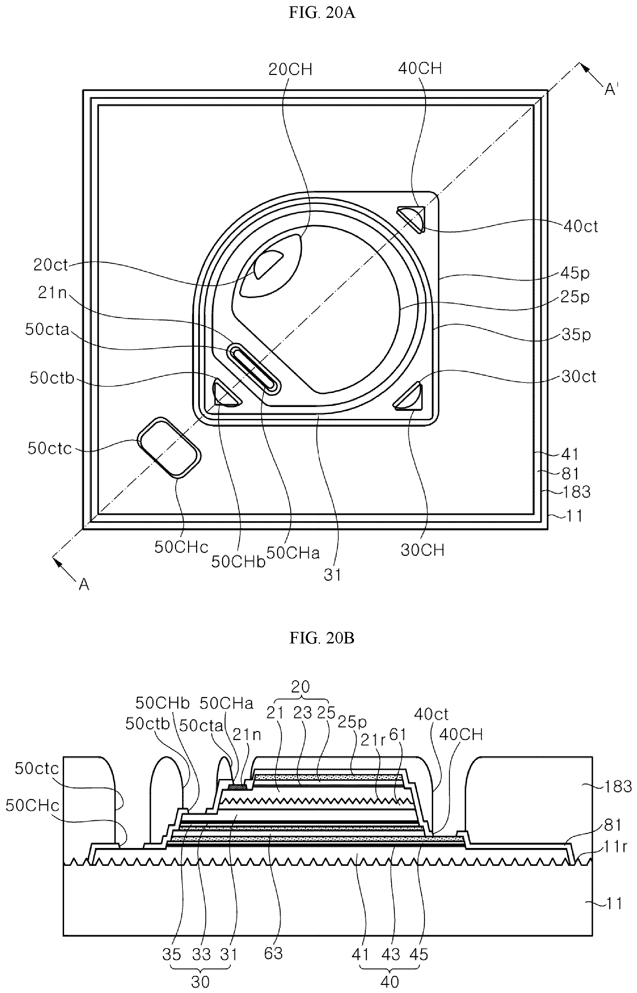

Referring to FIGs. 20A and 20B, an upper insulation layer 183 may be formed on the lower insulation layer 81. The upper insulation layer 183 may include epoxy molding compound (EMC), or the like, without being limited thereto. For example, the upper insulation layer 183 may be formed of a photosensitive polyimide dry film (PID). The upper insulation layer 183 may be transparent, or may have various colors such as black, white, and others, and may prevent light from leaking to the side surface of the light emitting device 200 to prevent or suppress interference of light emitted from an adjacent light emitting device 200.

The upper insulation layer 183 may be formed directly on the lower insulation layer 81, and thus, no other layers, such as conductive layers, are interposed between the lower insulation layer 81 and the upper insulation layer 183. However, the inventive concepts are not necessarily limited thereto.

The upper insulation layer 183 may be patterned to allow electrical connection to the first through third LED stacks 20, 30, and 40. The upper insulation layer 183 may be patterned using photolithography and development processes. For example, the upper insulation layer 183 may be patterned to have openings 20ct, 30ct, 40ct, 50cta, 50ctb, and 50ctc corresponding to the first through third contact holes 20CH, 30CH, and 40CH and the first through third sub-contact holes 50CHa, 50CHb, and 50CHc of the lower insulation layer 81. A first opening 20ct may at least partially overlap with the first contact hole 20CH, a second opening 30ct may at least partially overlap with the second contact hole 30CH, and a third opening 40ct may at least partially overlap with the third contact hole 40CH. In addition, first through third sub-openings 50cta, 50ctb, and 50ctc may at least partially overlap with the first through third sub-contact holes 50CHa, 50CHb, and 50CHc, respectively.

In this embodiment, it has been described that the first through third openings 50cta, 50ctb, and 50ctc are formed, but one opening exposing the first through third contact holes 50CHa, 50CHb, and 50CHc may be formed.

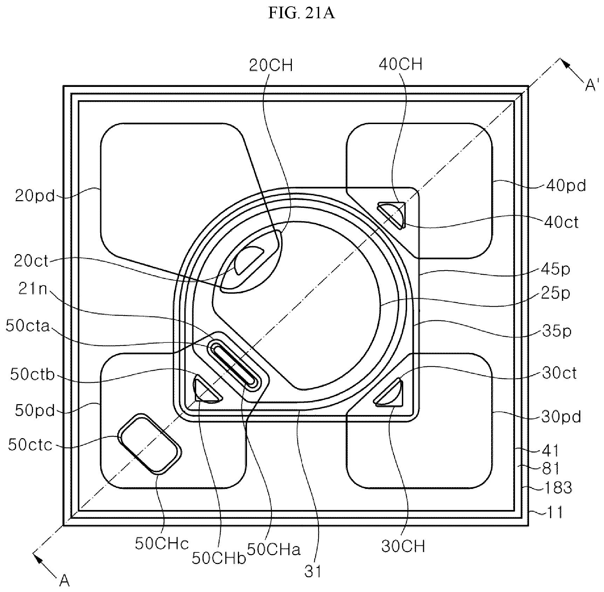

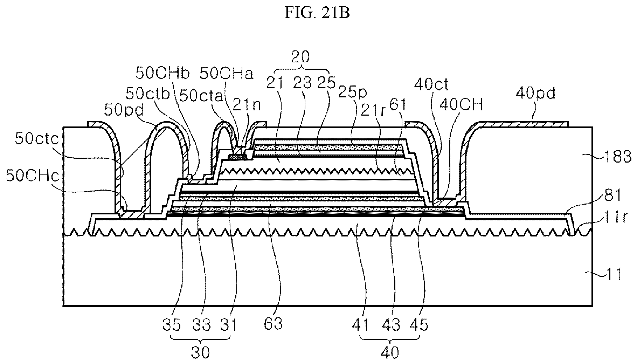

Referring to FIGs. 21A and 21B, first, second, third, and fourth electrode pad layers 20pd, 30pd, 40pd, and 50pd are formed on the upper insulation layer 183. The first through fourth electrode pad layers 20pd, 30pd, 40pd, and 50pd may be arranged in a diagonal direction of the substrate 11, as shown in FIG. 21A. The first, second, third, and fourth electrode pad layers 20pd, 30pd, 40pd, and 50pd may be formed by forming a conductive layer on an entire surface of the substrate 11, and then patterning it using photolithography and etching processes or using a lift-off a process.

The first electrode pad layer 20pd may be electrically connected to the first upper contact electrode 25p through the first opening 20ct and the first contact hole 20CH, and may be electrically connected to the second conductivity type semiconductor layer 25 through the first upper contact electrode 25p. The second electrode pad layer 30pd may be electrically connected to the second lower contact electrode 35p through the second opening 30ct and the second contact hole 30CH, and may be electrically connected to the second conductivity type semiconductor layer 35 through the second lower contact electrode 35p. The third electrode pad layer 40pd may be connected to the third upper contact electrode 45p through the third opening 40ct and the third contact hole 40CH, and may be electrically connected to the second conductivity type semiconductor layer 45 through the third upper contact electrode 45p. The fourth electrode pad layer 50pd may be connected to the ohmic contact layer 21n, the first conductivity type semiconductor layer 31, and the first conductivity type semiconductor layer 41 through the first through third sub-openings 50cta, 50ctb, and 50ctc and the first through third sub-contact holes 50CHa, 50CHb, and 50CHc. The fourth electrode pad layer 50pd may be commonly electrically connected to the first conductivity type semiconductors 21, 31, and 41 of the first, second, and third LED stacks 20, 30, and 40.

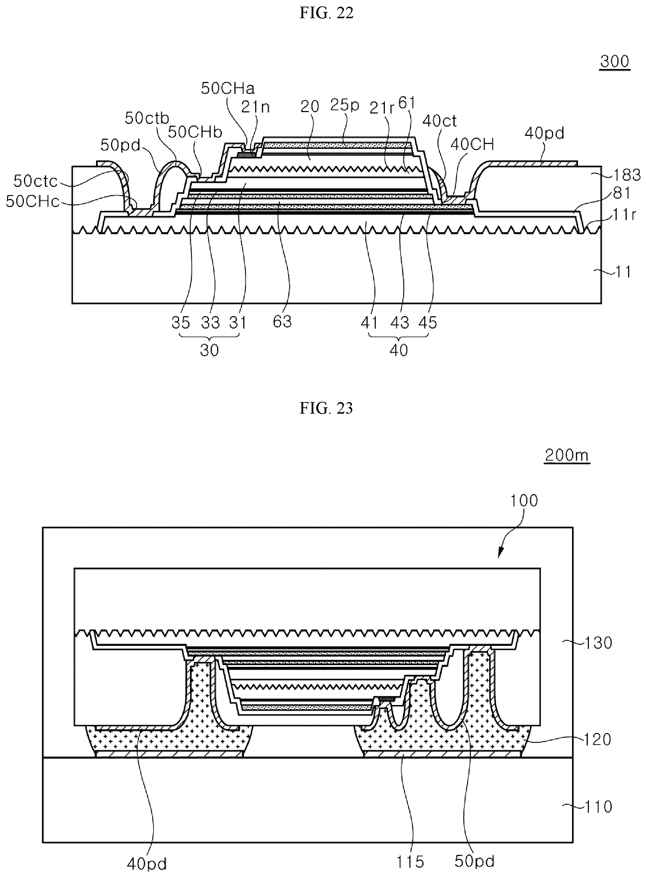

FIG. 22 is a schematic cross-sectional view illustrating a light emitting device 300 according to another embodiment of the present disclosure.

Referring to FIG. 22, the light emitting device 300 according to this embodiment is generally similar to the light emitting device 200 described with reference to FIGs. 12A, 12B, and 12C, except that a height of an upper surface of an upper insulation layer 183 is lower than that of an upper surface of a first LED stack 20.

The upper insulation layer 183 may be formed to have a thickness smaller than a total thickness of first through third LED stacks 20, 30, and 40, and the height of the upper surface of the upper insulation layer 183 may be smaller than that of the upper surface of the first LED stack 20. Meanwhile, according to this embodiment, since the upper surface of the first LED stack 20 is not covered with the upper insulation layer 183, it doesn't need to be formed along a first sub-opening 50CHa. In addition, a fourth electrode pad layer 50pd may include an upper surface having different heights depending on a location thereof, and may be positioned highest on the first LED stack 20.

In cross section view, the fourth electrode pad layer 50pd may include a convex portion P formed convexly along the surface of the upper insulation layer 183 between first through third sub-openings 50cta, 50ctb, and 50ctc. The convex portion P of the fourth electrode pad layer 50pd is formed in a direction opposite to a light extraction direction. The convex portion P may be formed in plural, and locations of vertices of the convex portions may be different from one another. The convex portion P may have different vertical lengths on both sides of the fourth electrode pad layer 50pd with respect to the vertex. Alternatively, the vertical length of the fourth electrode pad layer 50pd disposed close to the outside of the light emitting device may be longer.

FIG. 23 is a schematic cross-sectional view illustrating a light emitting module 200m according to an embodiment of the present disclosure.

Referring to FIG.23, the light emitting module 200m according to this embodiment includes a circuit board 110, a light emitting device 200, and a bonding layer 120. The circuit board 110 has pads 115 exposed on a surface thereof, and may also have interconnections connected inside or connected through a side surface. The circuit board 110 may be any material on which the light emitting device 200 can be mounted, such as a conductive circuit board, a printed circuit board, polyimide, or the like.

Although not shown in the drawings, an intermediate layer may be further disposed between first through fourth electrode pad layers 20pd, 30pd, 40pd, and 50pd and an upper insulation layer 183. The intermediate layer in the upper insulation layer 183 may cover surfaces of openings 20ct, 30ct, 40ct, 50cta, 50ctb, and 50ctc of the upper insulation layer 183. Accordingly, when the openings 20ct, 30ct, 40ct, 50cta, 50ctb, and 50ctc are formed, the intermediate layer may cover and smooth irregularities that may be formed on the surface of the upper insulation layer 183, and may block current leakage paths that may be formed on the surface. The intermediate layer may be formed of an insulating material, and may be any one of SiO₂, TiO₂, polyimide, and epoxy.

The light emitting device 200 may be flip-bonded to the pads 115 through the first through fourth electrode pad layers 20pd, 30pd, 40pd, and 50pd. A bonding agent such as solder or solder paste may be used to bond the light emitting device 200 and the circuit board 110, and thus, the bonding layers 120 may be formed between the light emitting device 200 and the circuit board 110.

Light generated in the first through third LED stacks 20, 30, and 40 may ultimately be emitted to the outside through a substrate 11. The light emitting device 200 may include at least four electrode pad layers 20pd, 30pd, 40pd, and 50pd, and thus, may be connected to four pads 115 on the circuit board 110. Although it has been described that the bonding layers 120 are formed using solder or solder paste, the inventive concepts are not limited thereto, and the light emitting device 200 may be coupled to the circuit board 110 by eutectic bonding, epoxy bonding, anisotropic conductive film (ACF), ball grid array (BGA), or the like.

Meanwhile, a molding member 130 may cover the light emitting device 200. The molding member 130 may transmit at least a portion of light emitted from the light emitting device 200, and may reflect, diffract, and absorb a portion of external light to prevent external light from being reflected by the light emitting device 200 in a direction visible to a user. The molding member 130 may cover at least a portion of the light emitting device 200 to protect the light emitting device 200 from moisture and an external impact. The molding member 130 may further include fillers such as silica, TiO₂, alumina, or the like. In an embodiment, the molding member 130 may include a same material as that of the upper insulation layer 183.

The molding member 130 may be formed through a method such as lamination or inkjet printing. For example, the molding member 130 is formed by a vacuum lamination process in which an organic polymer sheet is placed on the light emitting device 200 and high temperature and high pressure are applied in a vacuum, and thus, a flat upper surface of the light emitting module is provided, thereby improving light uniformity.

The molding member 130 may be formed to cover both an upper surface and side surfaces of the light emitting device 200. The molding member 130 may be formed of a transparent molding layer, or may be formed of a black matrix including a light absorbing material to prevent light diffusion.

In this embodiment, one light emitting device 200 is shown and described as being disposed on the circuit board 110, but the inventive concepts are not limited thereto. A plurality of light emitting devices 200 may be arranged on the circuit board 110. There is no particular limitation on the number of light emitting devices 200 disposed on the circuit board 110. For example, the light emitting devices 200 may be arranged in a 2x2 arrangement on the circuit board 110, without being limited thereto, and may be arranged in various matrices (n × m, n=1,2,3,4,..., m=1,2,3,4,... ). The circuit board 110 may include scan lines and data lines for independently driving each of the light emitting devices 200 included in a light emitting module 200m.

In this embodiment, it has been described that the light emitting device 200 is bonded to the circuit board 110, but the light emitting device 300 may also be bonded

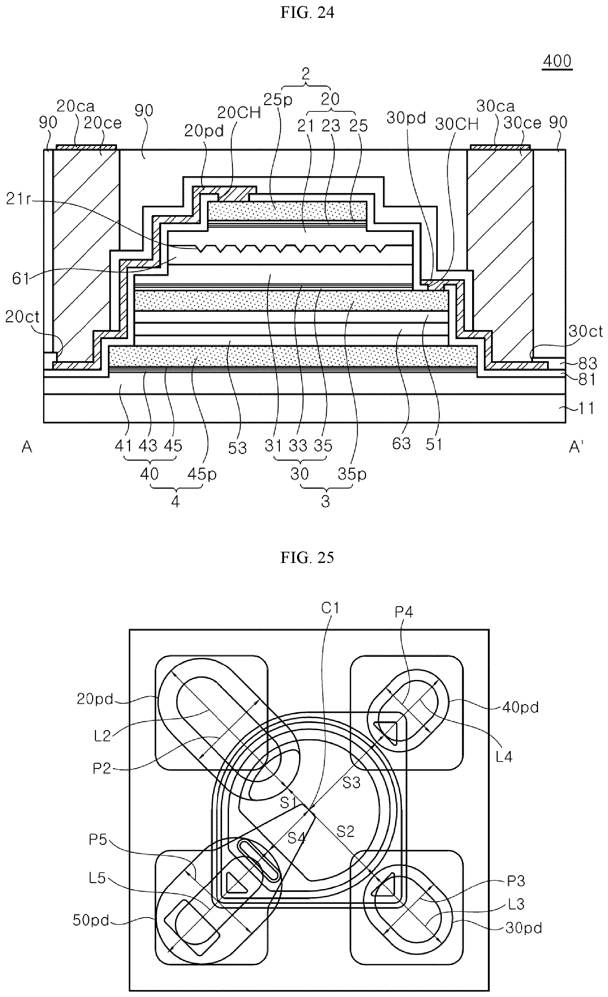

FIGs. 24 and 25 are a schematic cross-sectional view and a plan view illustrating a light emitting device 400 according to an embodiment of the present disclosure.

Referring to FIGs. 24 and 25, the light emitting device 400 may include first, second, and third subunits 2, 3, and 4, and the first, second, and third subunits 2, 3, and 4 may emit light of different peak wavelengths. An adhesive layer 61 and a second adhesive layer 63 may be disposed between the first, second, and third subunits 2, 3, and 4. The light emitting device 400 includes a plurality of pad electrodes 20pd, 30pd, 40pd, and 50pd electrically connected to the first, second, and third subunits 2, 3, and 4, and may further include first through fourth connection electrodes 20ce, 30ce, 40ce, and 50ce between the plurality of pad electrodes 20pd, 30pd, 40pd, and 50pd and an external circuit to electrically connect the light emitting device 400 to the external circuit. The light emitting device 400 may further include a protection layer 90 surrounding the connection electrodes 20ce, 30ce, 40ce, and 50ce.

A first pad electrode 20pd may be electrically connected to the first subunit 2, may be disposed to at least partially overlap with the first subunit 2, may be disposed to at least partially overlap with the second subunit 3, and may be disposed to at least partially overlap with the third subunit 4. That is, the first pad electrode 20pd may overlap with at least three subunits.

A second pad electrode 30pd may be electrically connected to the second subunit 3, may be disposed to at least partially overlap with the second subunit 3, and may be spaced apart from the first subunit 2. Moreover, it may be disposed to at least partially overlap with the third subunit 4. The second pad electrode 30pd may overlap with at least two subunits.

A third pad electrode 40pd may be electrically connected to the third subunit 4, and may be spaced apart from the first subunit 2. Moreover, it may be spaced apart from the second subunit 3. The third pad electrode 40pd may overlap with one subunit.

A fourth pad electrode 50pd may be electrically connected to the first through third subunits 2, 3, and 4, may be disposed to at least partially overlap with the first subunit 2, may be disposed to at least partially overlap with the second subunit 3, and may be disposed to at least partially overlap with the third subunit 4. That is, the fourth pad electrode 50pd may overlap with at least three subunits. The fourth pad electrode 50pd may serve as a common electrode. The number of subunits overlapping with the third pad electrode 40pd may be smaller than the number of subunits overlapping with the other pad electrodes 20pd, 30pd, and 50pd.

Alternatively, the number of subunits overlapping with the fourth pad electrode 50pd may be same as the number of subunits overlapping with the first pad electrode 20pd.

Alternatively, 50% or more of the number of pad electrodes 20pd, 30pd, 40pd, and 50pd may be disposed to overlap with all of the first through third subunits 2, 3, and 4. Alternatively, the number of subunits overlapping with the first through third pad electrodes 20pd, 30pd, and 40pd may be different from one another.

In cross section view or plan view, each of the plurality of pad electrodes 20pd, 30pd, 40pd, and 50pd may have a different length from one another. Among the plurality of pad electrodes 20pd, 30pd, 40pd, and 50pd, a length L4 may be smallest. A length L3 of the second pad electrode 30pd may be greater than the length L4 of the third pad electrode 40pd. A length L2 of the first pad electrode 20pd may be greater than the lengths L3 and L4 of the second pad electrode 30pd and the third pad electrode 40pd. A length L5 of the fourth pad electrode 50pd may be smaller than the length L2 of the first pad electrode 20pd. Alternatively, the length L5 of the fourth pad electrode 50pd may be smaller than the length L3 of the second pad electrode 30pd, or may be smaller than the length L4 of the third pad electrode 40pd. The lengths L2, L3, L4, and L5 of the plurality of pad electrodes 20pd, 30pd, 40pd, and 50pd may have a relationship of L2>L5>L3>L4.

In cross section view or plan view, pad electrodes 20pd, 30pd, 40pd, and 50pd may have a minimum width P2, P3, P4, and P5, respectively, and each of the minimum widths P2, P3, P4, and P5 may be different from one another. Among the plurality of pad electrodes 20pd, 30pd, 40pd, and 50pd, the minimum width P4 of the third pad electrode 40pd may be smallest. The minimum width P3 of the second pad electrode 30pd may be greater than the minimum width P4 of the third pad electrode 40pd. The minimum width P2 of the first pad electrode 20pd may be greater than the minimum widths P3 and P4 of the second pad electrode 30pd and the third pad electrode 40pd. The minimum width P5 of the fourth pad electrode 50pd may be greater than the minimum widths P2 and P3 of the second pad electrode 30pd and the third pad electrode 40pd. The minimum widths P2, P3, P4, and P5 of the plurality of pad electrodes 20pd, 30pd, 40pd, and 50pd may have a relationship of P2 or P5>P3>P4.

The light emitting device 400 may include a center point C1 where diagonal lines of corners intersect, and the plurality of pad electrodes 20pd, 30pd, 40pd, and 50pd are spaced apart from the center point C1. The first pad electrode 20pd may be spaced apart from the center point C1 by a first distance S1, the second pad electrode 30pd may be spaced apart from the center point C1 by a second distance S2, the third pad electrode 40pd may be spaced apart from the center point C1 by a third distance S3, and the fourth pad electrode 50pd may be spaced apart from the center point C1 by a fourth distance S4. Each of the distances S1, S2, S3, and S4 may be different from one another.

The third distance S3 may be positioned on a same diagonal line as the fourth distance S4, the third distance S3 may be different from the fourth distance S4, and preferably, the third distance S3 may be greater than the fourth distance S4. Accordingly, the fourth pad electrode 50pd may be disposed closer to the center point C1 than the third pad electrode 40pd.

The second distance S2 may be positioned on a same diagonal line as the first distance S1, the second distance S2 may be different from the first distance S1, and preferably, the second distance S2 may be greater than the first distance S1. Accordingly, the first pad electrode 20pd may be disposed closer to the center point C1 than the second pad electrode 30pd.

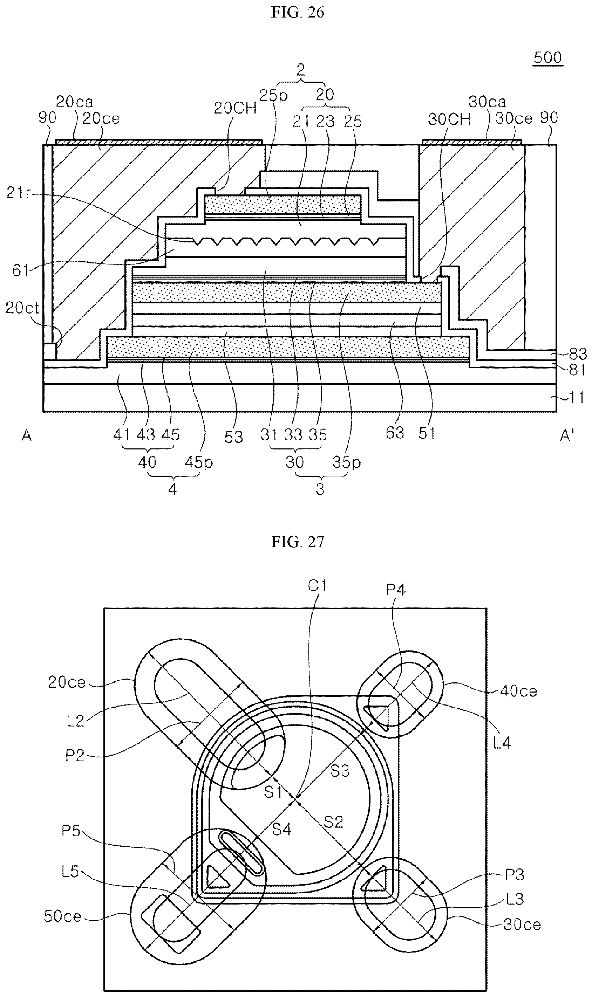

FIGs. 26 and 27 show another embodiment of the present disclosure, in which a light emitting device 500 does not necessarily include a plurality of pad electrodes 20pd, 30pd, 40pd, and 50pd and they may be omitted. Therefore, the shapes of the plurality of pad electrodes 20pd, 30pd, 40pd, and 50pd described above may be applied to first through fourth connection electrodes 20ce, 30ce, 40ce, and 50ce of the light emitting device 500.

The light emitting device 500 may include first, second, and third subunits 2, 3, and 4, and the first, second, and third subunits 2, 3, and 4 emit light of different peak wavelength from one another. An adhesive layer 61 and a second adhesive layer 63 may be disposed between the first, second, and third subunits 2, 3, and 4. The light emitting device 500 may further include the first through fourth connection electrodes 20ce, 30ce, 40ce, and 50ce between the first, second, and third subunits 2, 3, and 4 and an external circuit to electrically connect the light emitting device 500 to the external circuit. In addition, a protection layer 90 surrounding the connection electrodes 20ce, 30ce, 40ce, and 50ce may be included.

The first connection electrode 20ce may be electrically connected to the first subunit 2, may be disposed to at least partially overlap with the first subunit 2, may be disposed to at least partially overlap with the second subunit 3, and may be disposed to at least partially overlap with the third subunit 4. That is, the first connection electrode 20ce may overlap with at least three subunits.

The second connection electrode 30ce may be electrically connected to the second subunit 3, may be disposed to at least partially overlap with the second subunit 3, and may be spaced apart from the first subunit 2. Moreover, it may be disposed to at least partially overlap with the third subunit 4. The second connection electrode 30ce may overlap with at least two subunits.

The third connection electrode 40ce may electrically connected to the third subunit 4, and may be spaced apart from the first subunit 2. Moreover, it may be spaced apart from the second subunit 3. The third pad electrode 40pd may overlap with one subunit.

The fourth connection electrode 50ce may be electrically connected to the first through third subunits 2, 3, and 4, may be disposed to at least partially overlap with the first subunit 2, may be disposed to at least partially overlap with the second subunit 3, and may be disposed to at least partially overlap with the third subunit 4. That is, the fourth connection electrode 50ce may overlap with at least three subunits. The fourth connection electrode 50ce may function as a common electrode. The number of subunits overlapping with the third connection electrode 40ce may be smaller than the number of subunits overlapping with the other connection electrodes 20ce, 30ce, and 50ce.

Alternatively, the number of subunits overlapping with the fourth connection electrode 50ce may be same as the number of subunits overlapping with the first connection electrode 20ce.

Alternatively, 50% or more of the number of a plurality of connection electrodes 20ce, 30ce, 40ce, and 50ce may be disposed to overlap with all of the first through third subunits 2, 3, and 4. Alternatively, the number of subunits overlapping between the first through third connection electrodes 20ce, 30ce, and 40ce may be different from one another.

In cross section view or plan view, each of the plurality of connection electrodes 20ce, 30ce, 40ce, and 50ce may have a different length from one another. Among the plurality of connection electrodes 20ce, 30ce, 40ce, and 50ce, a length L4 of the third connection electrode 40ce may be smallest. A length L3 of the second connection electrode 30ce may be greater than the length L4 of the third connection electrode 40ce. A length L2 of the first connection electrode 20ce may be greater than the lengths L3 and L4 of the second connection electrode 30ce and the third connection electrode 40ce. A length L5 of the fourth connection electrode 50ce may be smaller than the length L2 of the first connection electrode 20ce. Alternatively, the length L5 of the fourth connection electrode 50ce may be smaller than the length L3 of the second connection electrode 30ce, or may be smaller than the length L4 of the third connection electrode 40ce. The lengths L2, L3, L4, and L5 of the plurality of connection electrodes 20ce, 30ce, 40ce, and 50ce may have a relationship of L2>L5>L3>L4.

In cross section view or plan view, each of the plurality of connection electrodes 20ce, 30ce, 40ce, and 50ce may have a minimum width P2, P3, P4, and P5, respectively, and each of the minimum widths P2, P3, P4, and P5 may be different from one another. Among the plurality of connection electrodes 20ce, 30ce, 40ce, and 50ce, the minimum width P4 of the third connection electrode 40ce may be smallest. The minimum width P3 of the second connection electrode 30ce may be greater than the minimum width P4 of the third connection electrode 40ce. The minimum width P2 of the first connection electrode 20ce may be greater than the minimum widths P3 and P4 of the second connection electrode 30ce and the third connection electrode 40ce. The minimum width P5 of the fourth connection electrode 50ce may be greater than the minimum widths P2 and P3 of the second connection electrode 30ce and the third connection electrode 40ce. The minimum widths P2, P3, P4, and P5 of the plurality of connection electrodes 20ce, 30ce, 40ce, and 50ce may have a relationship of P2 or P5>P3>P4.

The light emitting device 500 may include a center point C1 where diagonal lines of corners intersect, and the plurality of connection electrodes 20ce, 30ce, 40ce, and 50ce is spaced apart from the center point C1. The first connection electrode 20ce may be spaced apart from the center point C1 by a first distance S1, the second connection electrode 30ce may be spaced apart from the center point C1 by a second distance S2, the third connection electrode 40ce may be spaced apart from the center point C1 by a third distance S3, and the fourth connection electrode 50ce may be spaced apart from the center point C1 by a fourth distance S4. Each of the distances S1, S2, S3, and S4 may be different from one another.

The third distance S3 may be positioned on a same diagonal line as the fourth distance S4, the third distance S3 may be different from the fourth distance S4, and preferably, the third distance S3 may be greater than the fourth distance S4. Accordingly, the fourth connection electrode 50ce may be disposed closer to the center point C1 than the third connection electrode 40ce.

The second distance S2 may be positioned on a same diagonal line as the first distance S1, the second distance S2 may be different from the first distance S1, and preferably, the second distance S2 may be greater than the first distance S1. Accordingly, the first connection electrode 20ce may be disposed closer to the center point C1 than the second connection electrode 30ce.

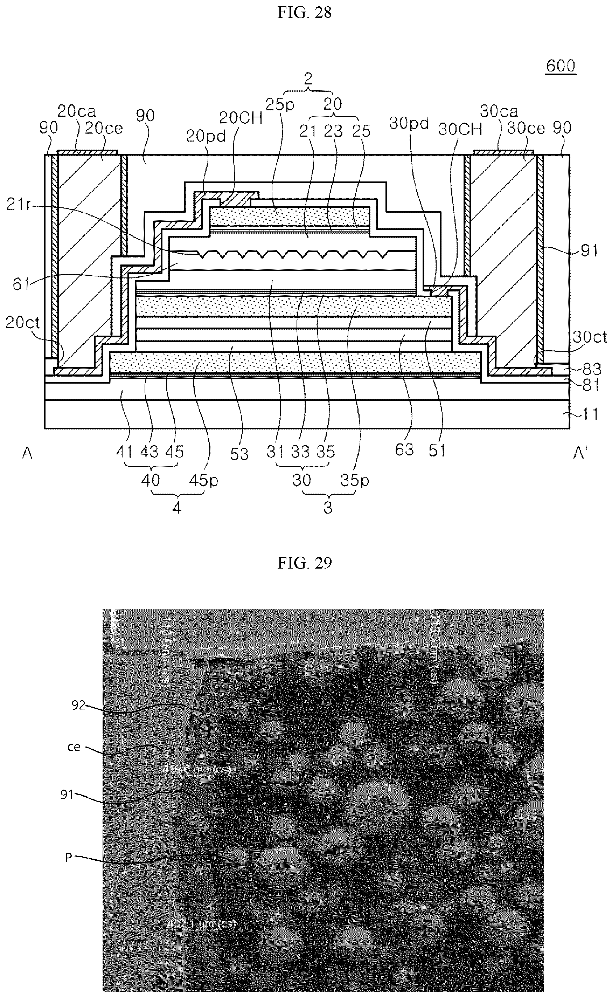

FIGs. 28 and 29 show another embodiment of the present disclosure, in which a light emitting device 600 may further include a protection layer 90 and a third adhesive layer 91 disposed on side surfaces of connection electrodes 20ce, 30ce, 40ce, and 50ce.

The third adhesive layer may be formed to surround each of the connection electrodes 20ce, 30ce, 40ce, and 50ce. The third adhesive layer 91 may be disposed between the connection electrodes 20ce, 30ce, 40ce, and 50ce and the protection layer 90 to bond the connection electrodes 20ce, 30ce, 40ce, and 50ce and the protection layer 90. The third adhesive layer 91 may be formed of an oxide film, and may be SiO₂ or TiO₂. A thickness of the third adhesive layer 91 may be smaller than widths or thicknesses of the connection electrodes 20ce, 30ce, 40ce, and 50ce, and preferably, may be formed to have a thickness of 1 µm or less. A side surface of the third adhesive layer 91 may have a non-uniform shape, and may include grooves and protrusions. Accordingly, a surface area may be increased, and thus, adhesion to the connection electrodes 20ce, 30ce, 40ce, and 50ce may be increased.

The protection layer 90 may include at least one particle P having a refractive index different from that of the protection layer 90. Alternatively, the particle P may be formed in plural, and may be a plurality of particles P having different sizes. The particle P and the third adhesive layer 91 may include a same component or element. The same component or element may be at least one of Si or Ti or O. Accordingly, adhesion between the third adhesive layer 91 and the protection layer 90 may be increased.

The side surface of the third adhesive layer 91 may be in contact with a plurality of materials having different refractive indices. Preferably, the side surface of the third adhesive layer 91 may be formed to contact with the protection layer 90 having a first refractive index and the particles P having a second refractive index.

The third adhesive layer 91 may have a side surface inclined with respect to a plane of a circuit board. A void 92 may be formed between the third adhesive layer 91 and the connection electrode ce.

The light emitting devices 400, 500, and 600 described above may be manufactured into the light emitting module 100m or 200m as described with reference to FIG. 11 or 23. Detailed descriptions thereof are omitted to avoid redundancy.

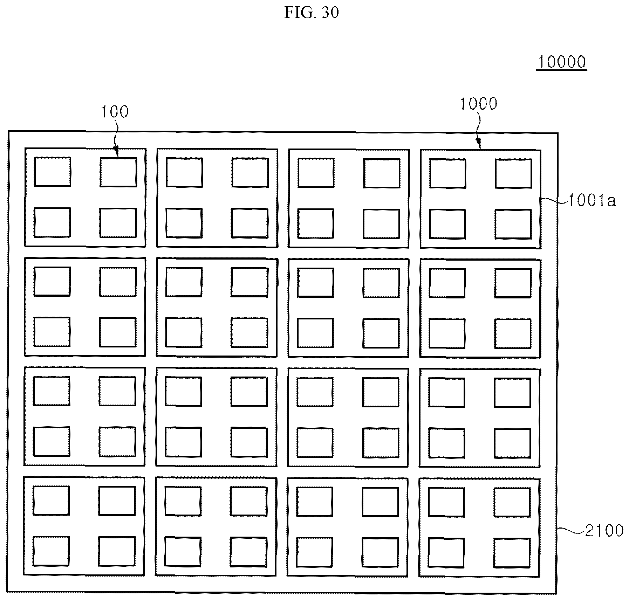

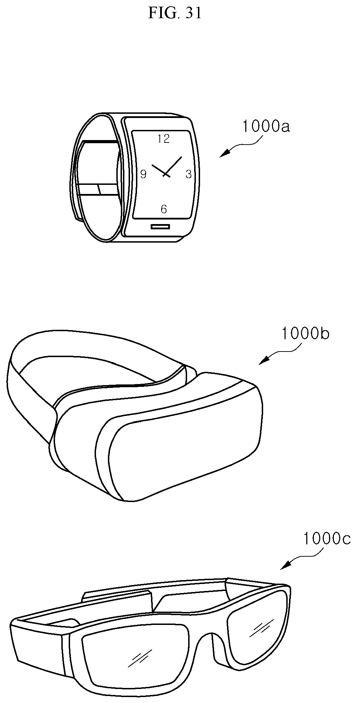

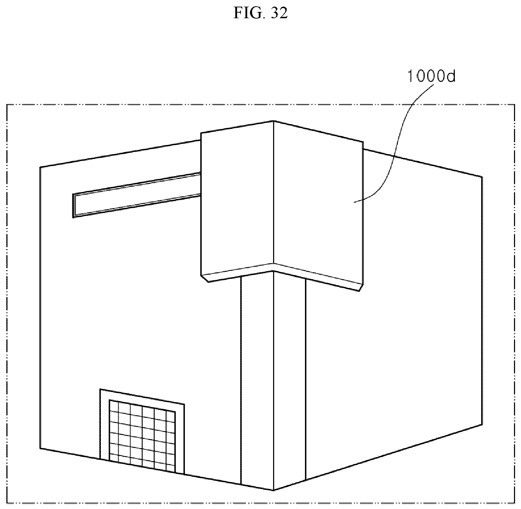

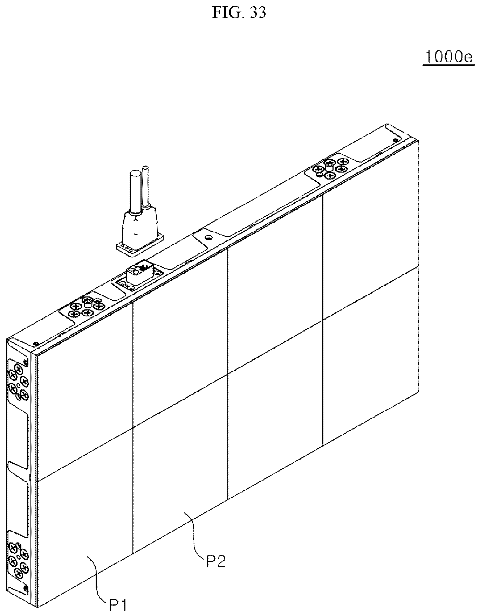

FIG. 30 is a schematic plan view illustrating a display apparatus according to an exemplary embodiment, and FIGs. 31, 32, and 33 are schematic perspective views illustrating various display apparatuses 1000a, 1000b, 1000c, 1000d, and 1000e according to an exemplary embodiment.

Referring to FIG. 30, a display apparatus 10000 may include a panel substrate 2100 and a plurality of pixel modules 1000. Herein, the pixel module 1000 represents a light emitting module including a plurality of light emitting devices 100.

The display apparatus 10000 is not particularly limited, but may include a smart watch 1000a, a wearable display apparatus 1000b such as a VR headset, glasses, or the like, an AR display apparatus 1000c such as augmented reality glasses, or the like, or an indoor or outdoor display apparatus 1000d and 1000e such as a micro LED TV, signage, or the like. The panel substrate 2100 and the plurality of pixel modules 1000 may be disposed within the display apparatus.

The panel substrate 2100 may include a circuit for passive matrix driving or active matrix driving. In an embodiment, the panel substrate 2100 may include interconnection lines and resistors therein, and in another embodiment, the panel substrate 2100 may include interconnections, transistors, and capacitors. The panel substrate 2100 may also have pads on its upper surface that can be electrically connected to a disposed circuit.

In an embodiment, the plurality of pixel modules 1000 is arranged on the panel substrate 2100. Each of the pixel modules1000 may include a circuit board 1001a and a plurality of light emitting devices 100, and may include a molding member covering the light emitting devices 100.

A brightness of the smart watch 1000a may be 500~1500cd/m² (or nits) or more, and the brightness may be adjusted depending on an external illumination level. A brightness of the wearable display apparatus 1000b such as VR headsets or glasses may be 150~200 cd/m² (or nits), or a viewing angle may be 50 degrees or more. A brightness of the indoor or outdoor display apparatus 1000d and 1000e such as micro LED TV or signage may be 1000cd/m² (or nits) or more, or a viewing angle may be 80 degrees or more, and is preferable 3000 cd/m² (or nits) or more, especially for outdoor use. In the display apparatuses 1000d and 1000e, a plurality of panels P1 and P2 is arranged in rows and columns and attached to a frame, and a plurality of micro LED pixels may be arranged on the plurality of panels P1 and P2 to be lit or adjusted according to an electric supply or a signal. The plurality of panels P1 and P2 may be connected to an external power source using respective connectors, or the plurality of panels P1 and P2 may be electrically connected to one another using connectors.

Although some exemplary embodiments have been described herein, it should be understood that these exemplary embodiments are provided for illustration only and are not to be construed in any way as limiting the present disclosure. It should be understood that features or components of one exemplary embodiment can also be applied to other exemplary embodiments without departing from the spirit and scope of the present disclosure.

## Claims

1. A light emitting device, comprising:
a substrate;
a first LED stack disposed on the substrate, and including a first conductivity type semiconductor layer, an active layer, and a second conductivity type semiconductor layer;
a second LED stack disposed between the substrate and the first LED stack, and including a first conductivity type semiconductor layer, an active layer, and a second conductivity type semiconductor layer;
a third LED stack disposed between the substrate and the second LED stack; and including a first conductivity type semiconductor layer, an active layer, and a second conductivity type semiconductor layer;
a lower insulation layer covering the first through third LED stacks;
an upper insulation layer disposed on the lower insulation layer; and
electrode pad layers disposed on the upper insulation layer, and electrically connected to the first through third LED stacks, wherein:
the lower insulation layer has openings allowing electrical connection to the first through third LED stacks,
the upper insulation layer covers the lower insulation layer such that each of the openings of the lower insulation layer is at least partially exposed, and
the electrode pad layers extend on the upper insulation layer to pass through openings in the lower insulation layer.

2. The light emitting device of claim 1,
wherein one of the electrode pad layers passes through a plurality of openings of the lower insulation layer to be commonly electrically connected to the first conductivity type semiconductor layers of the first through third LED stacks.

3. The light emitting device of claim 2, further comprising:
an ohmic contact layer disposed on the first conductivity type semiconductor layer of the first LED stack,
wherein one of the electrode pad layers is connected to the ohmic contact layer.

4. The light emitting device of claim 3,
wherein one of the electrode pad layers directly contacts the first conductivity type semiconductor layers of the second LED stack and the third LED stack.

5. The light emitting device of claim 2,
wherein three of the electrode pad layers are electrically connected to second conductivity type semiconductor layers of the first through third LED stacks, respectively, through different openings of the lower insulation layer.

6. The light emitting device of claim 5, further comprising:
transparent electrode layers respectively disposed on the second conductivity type semiconductor layers of the first through third LED stacks,
wherein three of the electrode pad layers are connected to the transparent electrode layers, respectively.

7. The light emitting device of claim 1,
wherein the upper insulation layer has openings corresponding to the openings in the lower insulation layer.

8. The light emitting device of claim 1,
wherein a height of an upper most surface of the upper insulation layer is lower than that of an upper most surface of the lower insulation layer.

9. The light emitting device of claim 1,
wherein at least one of the electrode pad layers includes a curved upper surface.

10. The light emitting device of claim 1,
wherein each of the electrode pad layers extends toward a center and an outside of the light emitting device from the opening of the lower insulation layer, and at least one electrode pad layer extends more lengthily to the outside of the light emitting device than to the center of the light emitting device from the opening of the lower insulation layer.

11. A light emitting module, comprising:
a circuit board with pads;
a light emitting device disposed on the circuit board; and
bonding layers for bonding the light emitting device to the circuit board,
the light emitting device, comprising:
a substrate;
a first LED stack disposed on the substrate, and including a first conductivity type semiconductor layer, an active layer, and a second conductivity type semiconductor layer;
a second LED stack disposed between the substrate and the first LED stack, and including a first conductivity type semiconductor layer, an active layer, and a second conductivity type semiconductor layer;
a third LED stack disposed between the substrate and the second LED stack; and
including a first conductivity type semiconductor layer, an active layer, and a second conductivity type semiconductor layer;
a lower insulation layer covering the first through third LED stacks;
an upper insulation layer disposed on the lower insulation layer; and
electrode pad layers disposed on the upper insulation layer, and electrically connected to the first through third LED stacks, wherein:
the lower insulation layer has openings allowing electrical connection to the first through third LED stacks,
the upper insulation layer covers the lower insulation layer such that each of the openings of the lower insulation layer is at least partially exposed, and
the electrode pad layers extend on the upper insulation layer to pass through openings in the lower insulation layer.

12. The light emitting module of claim 11,
wherein the bonding layers bond the electrode pad layers to the pads.

13. The light emitting module of claim 12,
wherein one of the electrode pad layers is commonly electrically connected to the first conductivity type semiconductor layers of the first through third LED stacks through a plurality of openings of the lower insulation layer.

14. The light emitting module of claim 13,
wherein one of the electrode pad layers directly contacts the first conductivity type semiconductor layers of the second LED stack and the third LED stack.

15. The light emitting module of claim 13,
wherein three of the electrode pad layers are electrically connected to second conductivity type semiconductor layers of the first through third LED stacks, respectively, through different openings of the lower insulation layer.

16. The light emitting module of claim 11, wherein:
the lower insulation layer includes a distributed Bragg reflector, and
the lower insulation layer contacts the first conductivity type semiconductor layers of the first through third LED stacks.

17. A light emitting device, comprising:
a first subunit including a first conductivity type semiconductor layer, an active layer, and a second conductivity type semiconductor layer;
a second subunit disposed over the first subunit, and including a first conductivity type semiconductor layer, an active layer, and a second conductivity type semiconductor layer;
a third subunit disposed over the second subunit, and including a first conductivity type semiconductor layer, an active layer, and a second conductivity type semiconductor layer; and
and first through third pad electrodes electrically connected to the second conductivity type semiconductor layers of the first through third subunits, respectively,
wherein the number of subunits overlapping with each of the first through third pad electrodes is different from one another.

18. The light emitting device of claim 17, wherein:
the first pad electrode is electrically connected to the first subunit,
the second pad electrode is electrically connected to the second subunit, and
the third pad electrode is electrically connected to the third subunit.

19. The light emitting device of claim 17, further comprising:
a fourth pad electrode,
wherein the number of subunits overlapping with at least one of the first through third pad electrodes is equal to the number of subunits overlapping with the fourth pad electrode.

20. The light emitting device of claim 17,
wherein each of the first to third pad electrodes has different lengths.
